# EUROPÄISCHE PATENTANMELDUNG

(11) **EP 3 613 793 A1**
(43) Veröffentlichungstag der Anmeldung: **26.02.2020**
(21) Anmeldenummer: 18190475.6
(22) Anmeldetag: 23.08.2018
(51) Int. Cl.: C08G 77/04, C08G 77/06, C08L 83/04, H01L 23/29

(54) **ZUSAMMENSETZUNGSPRECURSOR, ZUSAMMENSETZUNG, VERFAHREN ZUR HERSTELLUNG EINES ZUSAMMENSETZUNGSPRECURSORS, VERFAHREN ZUR HERSTELLUNG EINER ZUSAMMENSETZUNG, VERWENDUNG EINER ZUSAMMENSETZUNG UND BAUELEMENT**

(71) Anmelder: Universität des Saarlandes, 66123 Saarbrücken (DE)
(72) Erfinder: Kickelbick, Guido, 66386 St. Ingbert (DE); Steinbrück, Nils, 66117 Saarbrücken (DE); Pohl, Svenja, 66111 Saarbrücken (DE)
(74) Vertreter: Epping - Hermann - Fischer

(57) **Zusammenfassung**

Es wird ein Zusammensetzungsprecursor angegeben, der ein dreidimensionales Netzwerk aus teilweise miteinander vernetzten Monomereinheiten und einem alkoxyterminierten Oligo- oder Polysiloxan aufweist, wobei die Monomereinheiten zumindest ein Trialkoxysilan und zumindest ein Dialkoxysilan umfassen. Weitere Gegenstände sind eine Zusammensetzung, ein Verfahren zur Herstellung eines Zusammensetzungsprecursors sowie einer Zusammensetzung, eine Verwendung einer Zusammensetzung sowie ein Bauelement.

## Beschreibung

Die Anmeldung betrifft einen Zusammensetzungsprecursor, eine Zusammensetzung, ein Verfahren zur Herstellung eines Zusammensetzungsprecursors, ein Verfahren zur Herstellung einer Zusammensetzung, eine Verwendung der Zusammensetzung sowie ein Bauelement.

In vielen Bereichen werden Polysiloxane eingesetzt. Es werden immer höhere Ansprüche an diese Materialien gestellt, sodass kommerziell erhältliche Systeme verbessert werden müssen. Eine mögliche Anwendung von Polysiloxanen ist beispielsweise die Verkapselung von optoelektronischen Bauelementen. Die Arbeitsbedingungen von lichtemittierenden Dioden (LEDs) erfordern beispielsweise eine hohe photophysikalische und thermische Stabilität, eine hohe Transparenz, einen hohen Brechungsindex sowie eine gute Verarbeitbarkeit der gehärteten und nicht gehärteten Verkapselungsmaterialien, um eine hohe Effizienz und eine lange Lebensdauer des Bauelements zu gewährleisten.

So werden beispielsweise auf Polysiloxan basierende Verkapselungsmaterialien herangezogen, die auf ZweiKomponenten Elastomer-Systemen basieren und mittels eines Platinkatalysators thermisch härtbar sind. Aus ökologischen und wirtschaftlichen Gründen sollte der Einsatz von nichtrecycelbaren Edelmetallen wie Platin jedoch vermieden werden. Bislang bekannte epoxybasierte Polysiloxane, welche ohne Platin gehärtet werden können, sind jedoch wärme- oder lichtempfindlich, sodass beispielsweise eine Verfärbung aufgrund des Vorhandenseins der Epoxygruppen auftritt. Auch ist oft eine hohe Flexibilität der Materialien erforderlich, welche bislang nicht realisiert werden konnte.

Aufgabe mindestens einer Ausführungsform der Erfindung ist es, einen Zusammensetzungsprecursor bereitzustellen, der verbesserte Eigenschaften aufweist. Eine weitere Aufgabe der Erfindung ist es, eine Zusammensetzung bereitzustellen, welche verbesserte Eigenschaften aufweist. Weitere Aufgaben sind die Bereitstellung eines Verfahrens zur Herstellung eines Zusammensetzungsprecursors mit verbesserten Eigenschaften sowie ein Verfahren zur Herstellung einer Zusammensetzung mit verbesserten Eigenschaften. Eine weitere Aufgabe der Erfindung ist es, eine Verwendung der Zusammensetzung mit verbesserten Eigenschaften bereitzustellen. Schließlich ist es eine weitere Aufgabe der Erfindung, ein Bauelement bereitzustellen, welches die Zusammensetzung enthält und verbesserte Eigenschaften aufweist.

Diese Aufgaben werden durch die Gegenstände der unabhängigen Ansprüche gelöst. Vorteilhafte Ausgestaltungen und Weiterbildungen der Erfindung sind Gegenstand abhängiger Ansprüche und der Beschreibung.

Es wird ein Zusammensetzungsprecursor angegeben, der ein dreidimensionales Netzwerk aus teilweise miteinander vernetzten Monomereinheiten und einem alkoxyterminierten Oligo- oder Polysiloxan aufweist.

Unter einem Zusammensetzungsprecursor ist hier und im Folgenden ein Material zu verstehen, welches mittels Einwirkung äußerer Einflüsse zu einer Zusammensetzung umwandelbar ist. Durch die äußeren Einflüsse werden chemische Reaktionen in dem Zusammensetzungsprecursor initiiert, welche die chemische Struktur des Zusammensetzungsprecursors derart verändern, dass er zu der Zusammensetzung umgewandelt wird. Durch das Material der Zusammensetzung bedingte Eigenschaften können durch gezielte Einstellung der Eigenschaften des Zusammensetzungsprecursors erzielt werden.

Der Zusammensetzungsprecursor kann ein polymeres Material sein, welches das dreidimensionale Netzwerk aufweist. Dabei ist zu beachten, dass nicht alle Bestandteile des Zusammensetzungsprecursors vernetzt sein müssen, sondern auch einzeln vorliegen können. Somit umfasst der Zusammensetzungsprecursor Monomereinheiten, alkoxyterminiertes Oligo- oder Polysiloxan sowie durch chemische Bindungen miteinander verbundene Monomereinheiten sowie Monomereinheiten und alkoxyterminiertes Oligo- oder Polysiloxan, die durch chemische Bindungen miteinander verbunden sind.

Unter "Monomereinheiten" sind daher hier und im Folgenden somit sowohl unreagierte Monomere zu verstehen sowie Einheiten einer polymeren Kette, die auf diese Monomere zurückzuführen sind.

Gemäß einer Ausführungsform umfassen die Monomereinheiten zumindest ein Trialkoxysilan und zumindest ein Dialkoxysilan.

Dass die Monomereinheiten zumindest ein Trialkoxysilan (im Folgenden auch als TAS bezeichnet) und zumindest ein Dialkoxysilan (im Folgenden auch DAS bezeichnet)umfassen, bedeutet in diesem Zusammenhang, dass auch mindestens zwei verschiedene Trialkoxysilane beziehungsweise mindestens zwei verschiedene Dialkoxysilane als Monomereinheiten in dem Zusammensetzungsprecursor vorhanden sein können.

Der aus mindestens einem TAS, mindestens einem DAS und einem alkoxyterminierten Oligo- oder Polysiloxan teilweise vernetzte Zusammensetzungsprecursor kann eine gelartige Konsistenz aufweisen und somit bei Raumtemperatur beispielsweise in flüssiger oder zähflüssiger Form vorliegen.

Die Viskosität und der Brechungsindex des Zusammensetzungsprecursors können durch die Auswahl der Ausgangsmaterialien, also der Monomereinheiten und des alkoxyterminierten Oligo- oder Polysiloxans, und dem Verhältnis der Anteile der jeweiligen Ausgangsmaterialien eingestellt werden. Beispielsweise stehen diese Eigenschaften in direktem Zusammenhang mit dem Verhältnis von eingesetzten TAS zu DAS und dem Anteil von bestimmten Gruppen, insbesondere sperrige Gruppen wie Arylgruppen, der Monomereinheiten. Weiterhin führt das alkoxyterminierte Oligo- oder Polysiloxan zu einem aufgeweiteten dreidimensionalen Netzwerk aus den teilweise miteinander vernetzten Monomereinheiten, was wiederum einen Einfluss auf die Viskosität hat.

Durch die Einstellung der Viskosität und des Brechungsindex des Zusammensetzungsprecursors kann auch die Härte und der Brechungsindex einer aus dem Zusammensetzungsprecursor hergestellten Zusammensetzung beeinflusst und damit je nach gewünschter Anwendung eingestellt werden.

Gemäß einer Ausführungsform wird ein Zusammensetzungsprecursor angegeben, der ein dreidimensionales Netzwerk aus teilweise miteinander vernetzten Monomereinheiten und einem alkoxyterminierten Oligo- oder Polysiloxan aufweist, wobei die Monomereinheiten zumindest ein Trialkoxysilan und zumindest ein Dialkoxysilan aufweisen.

Gemäß einer weiteren Ausführungsform weist der Zusammensetzungsprecursor die allgemeine Strukturformel 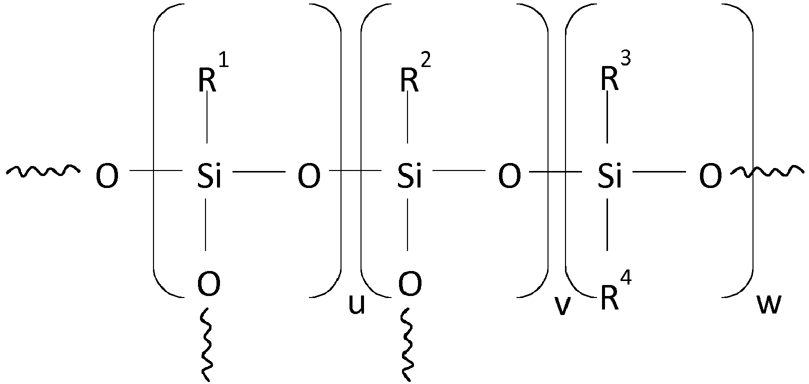 auf. Dabei können R¹, R², R³ und R⁴ unabhängig voneinander ausgewählt sein aus Aryl, Alkyl, Alkenyl, Allyl, substituiertem Aryl, substituiertem Alkenyl, substituiertem Alkyl und Vinyl, vorzugsweise aus Phenyl und Methyl, wobei u+v+w die Anzahl der eingesetzten Si-Atome ist und u, v und w unabhängig voneinander aus dem Bereich 1 bis 20000 ausgewählt sind.

In dieser Strukturformel ist zu beachten, dass die mit u, v und w indizierten Gruppen statistisch in dem zumindest teilweise vernetzten Netzwerk verteilt sind. Es können somit auch andere Reihenfolgen der Gruppen in dem Netzwerk auftreten.

Beispielsweise können in dem Zusammensetzungsprecursor somit teilweise miteinander vernetzte oder auch nicht vernetzte Phenyltrimethoxysilan PhSi(OMe)₃ und Methyltrimethoxysilan MeSi(OMe)₃ als Trialkoxysilane, Dimethyldimethoxysilan Me₂Si(OMe)₂ als Dialkoxysilan sowie methoxyterminiertes Polydimethylsiloxan, PDMSi₁₁(OMe)₂ als alkoxyterminiertes Oligo- oder Polysiloxan eingesetzt werden. Deren allgemeinen Strukturen sind im Folgenden gezeigt:

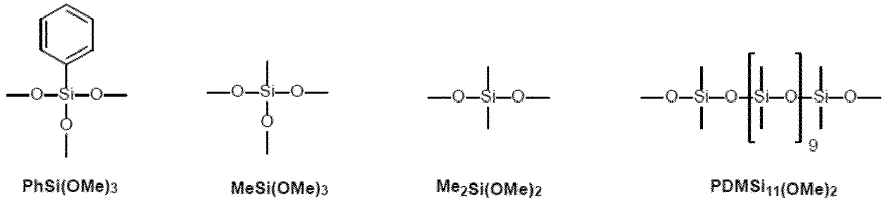

Gemäß diesem Beispiel kann die allgemeine Strukturformel eines solchen daraus gebildeten Netzwerkes folgendermaßen aussehen:

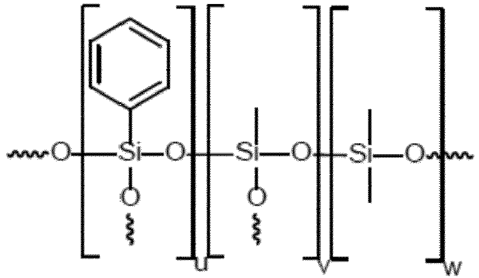

Je höher der Anteil an DAS in Bezug auf TAS und alkylterminiertem Oligo- oder Polysiloxan ist, desto aufgeweiteter und weniger quervernetzt ist die Struktur des Zusammensetzungsprecursors und damit auch der daraus entstehenden Zusammensetzung, was die Viskosität des Zusammensetzungsprecursors beziehungsweise die Härte der Zusammensetzung signifikant verringert. Gleichzeitig kann der Brechungsindex aufgrund des größeren Verhältnisses von beispielsweise Phenyl- zu Methylgruppen steigen.

Gemäß einer weiteren Ausführungsform ist der Anteil an alkoxyterminiertem Oligo- oder Polysiloxan in dem Zusammensetzungsprecursor aus einem Bereich von > 0 % bis 10 % der Summe der Stoffmengen an Trialkoxysilan und Dialkoxysilan ausgewählt. Ein solcher Anteil ist ausreichend, um das dreidimensionale Netzwerk aufzuweiten und damit die Viskosität der Zusammensetzungsprecursors zu erniedrigen.

Gemäß einer weiteren Ausführungsform weist der Zusammensetzungsprecursor eine Viskosität bei 23°C auf, die in einem Bereich von 1000000 mPas bis 100 mPas liegt, und/oder eine Viskosität bei 110°C, die in einem Bereich von 10000 mPas bis 50 mPas liegt. Diese Viskositäten ermöglichen eine gute Verarbeitbarkeit des Zusammensetzungsprecursors. Zudem bedingen sie eine Härte der aus dem Zusammensetzungsprecursor hergestellten Zusammensetzung, die eine gewünschte Flexibilität und Elastizität der Zusammensetzung realisiert.

Gemäß einer weiteren Ausführungsform ist der Zusammensetzungsprecursor thermisch oder photochemisch aushärtbar. Das bedeutet, der Zusammensetzungsprecursor kann durch thermische oder photochemische Einwirkungen vollständig aushärten, sodass alle oder zumindest weitgehend alle Monomereinheiten und alkoxyterminierten Oligo- oder Polysiloxane miteinander zu einem dreidimensionalen Netzwerk vernetzt sind. Dieser Härtungsvorgang kann hier und im Folgenden auch als Konsolidierung bezeichnet werden.

Es wird weiterhin eine Zusammensetzung angegeben, die einen thermisch oder photochemisch ausgehärteten Zusammensetzungsprecursor gemäß einem der oben genannten Ausführungsformen umfasst. Sämtliche Merkmale, die in Zusammenhang mit dem Zusammensetzungsprecursor offenbart sind, gelten somit auch für die Zusammensetzung und umgekehrt.

Dadurch, dass die Zusammensetzung einen thermisch oder photochemisch ausgehärteten Zusammensetzungsprecursor enthält, ist sie nicht gelartig wie der Zusammensetzungsprecursor, sondern fest. Aufgrund der Eigenschaften des Zusammensetzungsprecursors weist die Zusammensetzung jedoch eine genügend hohe Elastizität auf, sodass sie gut in vielen Anwendungen, beispielsweise als Verkapselung in optoelektronischen Bauelementen, eingesetzt werden kann.

Gemäß einer weiteren Ausführungsform weist die Zusammensetzung eine Shore-A-Härte von 40 bis < 99 auf.

Je nach Eigenschaft des Zusammensetzungsprecursors kann die Zusammensetzung weiterhin einen hohen Brechungsindex aufweisen. Dieser kann größer oder gleich dem Brechungsindex des Zusammensetzungsprecursors sein.

Gemäß einer weiteren Ausführungsform ist die Zusammensetzung frei von einem Edelmetallkatalysator. Insbesondere ist die Zusammensetzung frei von einem Platinkatalysator. Somit ist die Zusammensetzung kosten- und prozessoptimiert herstellbar.

Basiert die Zusammensetzung auf einem Zusammensetzungsprecursor, der Phenyltrimethoxysilan PhSi(OMe)₃ und Methyltrimethoxysilan MeSi(OMe)₃ als Trialkoxysilane, Dimethyldimethoxysilan Me₂Si(OMe)₂ als Dialkoxysilan sowie methoxyterminiertes Polydimethylsiloxan, PDMSi₁₁(OMe)₂ als alkoxyterminiertes Oligo- oder Polysiloxan enthält, kann die ausgehärtete bzw. konsolidierte Struktur in einem beispielhaften Ausschnitt folgende schematische Formel aufweisen:

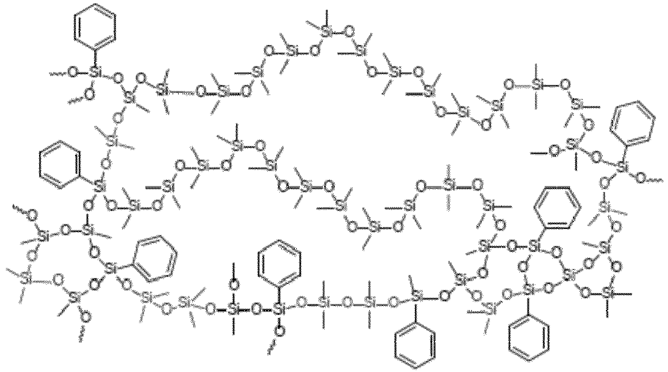

In dieser Formel sind die TAS- und DAS-Gruppen sowie die das Netzwerk aufweitenden PDMS-Gruppen zu erkennen.

Es wird weiterhin ein Verfahren zur Herstellung eines Zusammensetzungsprecursors angegeben. Das Verfahren weist die Schritte
A) Kondensation von mindestens einem Trialkoxysilan und mindestens einem Dialkoxysilan,
B) Kondensation des mindestens einen Trialkoxysilans und des mindestens einen Dialkoxysilans mit einem alkoxyterminierten Oligo- oder Polysiloxan,
C) Reinigung des kondensierten Trialkoxysilans, Dialkoxysilans und alkoxyterminierten Oligo- oder Polysiloxans auf.

Gemäß einer Ausführungsform kann der Verfahrensschritt B) nach dem Verfahrensschritt A) oder gleichzeitig mit dem Verfahrensschritt A) durchgeführt werden.

Unter Kondensation ist hier und im Folgenden eine Reaktion der Monomereinheiten untereinander beziehungsweise mit dem alkoxyterminierten Oligo- oder Polysiloxan zu verstehen, bei dem sich die Monomereinheiten und das alkoxyterminierte Oligo- oder Polysiloxan miteinander chemisch verbinden. Dabei bildet sich ein dreidimensionales Netzwerk aus. Es ist jedoch zu beachten, dass in diesem Verfahren nicht alle Monomereinheiten beziehungsweise nicht jedes alkoxyterminierte Oligo- oder Polysiloxan miteinander reagieren, sodass nur eine teilweise Vernetzung auftritt.

Es können in dem Verfahren auch mindestens zwei verschiedene Trialkoxysilane und/oder mindestens zwei verschiedene Dialkoxysilane kondensieren.

Unabhängig davon, ob die Verfahrensschritte A) und B) gleichzeitig oder nacheinander durchgeführt werden, kann mit diesem Verfahren eine statistische Verteilung der eingesetzten Bestandteile in dem Zusammensetzungsprecursor erhalten werden. Weiterhin sorgt das alkoxyterminierte Oligo- oder Polysiloxan dafür, dass sich ein aufgeweitetes Netzwerk aus miteinander kondensierten Monomereinheiten bildet.

Mit diesem Verfahren kann ein Zusammensetzungsprecursor gemäß den oben genannten Ausführungsformern hergestellt werden. Sämtliche in Zusammenhang mit dem Zusammensetzungsprecursor offenbarten Merkmale gelten somit auch für das Verfahren und umgekehrt.

Gemäß einer Ausführungsform werden die Verfahrensschritte A) und B) bei einer Temperatur durchgeführt, die aus dem Bereich 20°C bis 60°C ausgewählt ist, und/oder der Verfahrensschritt C) wird bei einer Temperatur durchgeführt, die aus dem Bereich 70°C bis 150°C ausgewählt ist. Bei diesen Temperaturen ist die Bildung eines dreidimensionalen Netzwerks aus zumindest teilweise miteinander vernetzten Trialkoxysilanen, Dialkoxysilanen und alkoxyterminiertem Oligo- oder Polysiloxan begünstigt.

Gemäß einer weiteren Ausführungsform wird der Verfahrensschritt A) unter Zugabe einer Säure oder einer Base durchgeführt. Als Säure können beispielsweise HCl, H₂SO₄, Essig oder Ameisensäure eingesetzt werden. Beispielhafte Basen sind NaOH, KOH, NH₄OH oder NH₃. Generell sind die eingesetzten Säuren oder Basen wasserlöslich. Wird eine Säure zugegeben, kann eine Protonierung der Alkoxygruppen und somit eine Erhöhung der Elektrophilie am Siliziumatom erzeugt werden. Dadurch können Wasser, Alkoxysilan- und Silanolgruppen angreifen und Methanol als Abgangsgruppe substituieren. Basen können direkt am nukleophilen Siliziumatom angreifen und einen geladenen Übergangszustand bilden. Die Alkoxysilangruppe kann somit in einer SN2-ähnlichen Reaktion substituiert werden. Wird im Verfahrensschritt A) eine Säure zugegeben, kann sich die Wahrscheinlichkeit zur Bildung von kettenartigen Strukturen erhöhen, wird eine Base zugegeben, kann sich die Wahrscheinlich zur Bildung von verzweigten Strukturen erhöhen.

Gemäß einer weiteren Ausführungsform wird vor dem Verfahrensschritt C) das kondensierte Trialkoxysilan, Dialkoxysilan und alkoxyterminierte Oligo- oder Polysiloxan bei Raumtemperatur gerührt. Das bedeutet, dass vor dem Reinigungsschritt C) eine Gelierung durchgeführt wird, wodurch die Viskosität des Materials ansteigt.

In dem Reinigungsschritt C) kann während der Gelierung entstandenes Wasser, sowie HCl und durch die Kondensation entstandenes Methanol entfernt werden.

Es wird weiterhin ein Verfahren zur Herstellung einer Zusammensetzung angegeben, bei dem ein gemäß den obigen Ausführungen hergestellter Zusammensetzungsprecursor thermisch oder photochemisch ausgehärtet wird. Durch die Einwirkung von Wärme oder Licht kann somit aus dem gelartigen Zusammensetzungsprecursor eine feste Zusammensetzung hergestellt werden. Sämtliche im Zusammenhang mit dem Verfahren zur Herstellung eines Zusammensetzungsprecursors genannten Merkmale gelten somit auch für das Verfahren zur Herstellung der Zusammensetzung und umgekehrt.

Gemäß einer weiteren Ausführungsform wird die thermische Aushärtung bei einer Temperatur aus dem Bereich 150°C bis 250°C und/oder für eine Dauer aus dem Bereich 8 h bis 72 h durchgeführt.

Eine photochemische Aushärtung kann bei Anwesenheit einer photochemisch aktivierbaren Gruppe in einem Monomer, beispielsweise einer Propylmethacrylatgruppe durchgeführt werden. Nach Zugabe eines Photoinitiators können diese Gruppen miteinander reagieren. Weiterhin können auch Photosäuren, die Protonen bei Belichtung freisetzen, zur Aktivierung der Aushärtung verwendet werden.

Gemäß einer weiteren Ausführungsform kann eine Base oder Säure als Katalysator zu dem Zusammensetzungsprecursor zugegeben werden. Bei Zugabe beispielsweise einer Base kann die Härtungszeit und Härtungstemperatur erheblich reduziert werden. Als Base können beispielsweise KOH oder DABCO (Triethylendiamin) verwendet werden. Der Anteil an Base kann beispielsweise < 10 mmol/g betragen.

Die mit dem Verfahren erhaltene Zusammensetzung ist frei von Rissen, je nach verwendetem Zusammensetzungsprecursor flexibel und elastisch und weist einen hohen Brechungsindex auf.

Es wird weiterhin die Verwendung einer Zusammensetzung gemäß den obigen Ausführungsformen angegeben. Die Verwendung der Zusammensetzung umfasst die Verwendung als Verkapselungsmaterial von optoelektronischen Bauelementen, als Matrixmaterial von Konversionsschichten, als Linsenmaterial, als Korrosionsschutzmaterial, als Komponente in Kompositmaterialien, in Lithographie-Prozessen und in der Drucktechnologie.

Beispielsweise kann die Zusammensetzung als Positiv in einem Prägelithographieprozess verwendet werden, in das ein Stempel gebracht wird. Weiterhin kann die Zusammensetzung beispielsweise photolithographischen Prozessen, insbesondere in einem photolithographischen 3D-Druck zur Anwendung kommen. Weiterhin kann die Zusammensetzung als Matrix für Farbstoffe dienen, beispielsweise in Solarzellen oder Luminescence solar concentrators, wobei dazu die Materialien mittels Inkjet-Verfahren in dünnen Filmen abgeschieden werden.

Aufgrund der Möglichkeit, in der Zusammensetzung den Brechungsindex sowie die Elastizität und Flexibilität einzustellen, kann die Zusammensetzung vorteilhaft in vielen Bereichen eingesetzt werden.

Es wird weiterhin Bauelement aufweisend mindestens ein Bauteil angegeben, das eine Zusammensetzung gemäß den obigen Ausführungen enthält. Das Bauelement kann gemäß einer Ausführungsform ein optoelektronisches Bauelement sein und eine Verkapselung aufweisend die Zusammensetzung und/oder eine Konversionsschicht aufweisend die Zusammensetzung enthalten.

Bei dem optoelektronischen Bauelement kann es sich beispielsweise um eine Leuchtdiode (LED) handeln und diese kann eine Halbleiterschichtenfolge aufweisen, welche zur Emission von Primärstrahlung geeignet ist. Eine LED kann eine Konversionsschicht aufweisen, die im Strahlengang der Primärstrahlung angeordnet ist und zur Umwandlung der Primärstrahlung in Sekundärstrahlung eingerichtet ist. Die Verkapselung kann derart in dem Bauelement angeordnet sein, dass sie die Halbleiterschichtenfolge umgibt.

Die Zusammensetzung ist als Verkapselungsmaterial von LEDs gut geeignet aufgrund ihres hohen Brechungsindex, ihrer hoher Transparenz und der Stabilität gegenüber Strahlung und Wärme.

Gemäß einer weiteren Ausführungsform kann die Zusammensetzung in der Konversionsschicht ein Matrixmaterial für einen die Primärstrahlung in Sekundärstrahlung umwandelnden Farbstoff sein. Hier ist die Zusammensetzung vorteilhaft einsetzbar, da sie licht- und wärmestabil ist und somit zu einer langen Lebensdauer und Zuverlässigkeit des Bauelements beitragen kann.

Weiterhin kann die Konversionsschicht als Plättchen oder als Verguss ausgeformt sein. Im Falle eines Vergusses kann die Konversionsschicht die Halbleiterschichtenfolge vollständig umgeben.

Wenn die Zusammensetzung in einem Bauelement eingesetzt werden soll, wird zunächst der Zusammensetzungsprecursor, in den gegebenenfalls weitere Stoffe wie beispielsweise Farbstoffe eingelagert sind, an dem gewünschten Ort aufgebracht. Das ist besonders gut durchführbar aufgrund der niedrigen Viskosität des Zusammensetzungsprecursors und damit seiner guten Verarbeitbarkeit. Sobald er aufgebracht wird, kann die Härtung bzw. Konsolidierung durchgeführt werden, wodurch sich die harte, aber immer noch elastische Zusammensetzung bildet, wobei die Härte der Zusammensetzung durch geeignete Einstellung des Zusammensetzungsprecursors eingestellt werden kann.

Weitere Vorteile, vorteilhafte Ausführungsformen und Weiterbildungen ergeben sich aus den im Folgenden in Verbindung mit den Figuren beschriebenen Ausführungsbeispielen.
Figur 1 zeigt eine schematische Ansicht der Verfahren zur Herstellung eines Zusammensetzungsprecursors und einer Zusammensetzung.
Figur 2 zeigt eine grafische Darstellung der Anteile von verwendeten Ausgangsmaterialien zur Herstellung des Zusammensetzungsprecursors gemäß verschiedenen Ausführungsbeispielen.
Figur 3 zeigt die absolute Viskosität von Ausführungsbeispielen des Zusammensetzungsprecursors anhand eines Blockdiagramms.
Figur 4 zeigt eine Darstellung der Brechungsindizes und des Gehalts an Phenylgruppen von Ausführungsbeispielen des Zusamensetzungsprecursors.
Figur 5 zeigt eine Darstellung der Shore-A-Härte von Ausführungsbeispielen der Zusammensetzung anhand eines Blockdiagramms.
Figur 6 zeigt Bilder von Plättchen gemäß Ausführungsbeispielen der Zusammensetzung.
Figuren 7a bis 7f zeigen Leiterrahmen ohne und mit Zusammensetzungsprecursoren und Zusammensetzungen gemäß Ausführungsbeispielen.
Figur 8 zeigt den thermogravimetrischen Massenverlust(a) und T₉₅-Werte (b) von Ausführungsbeispielen der Zusammensetzung.
Figur 9 zeigt die absolute Viskosität in Abhängigkeit der Zeit von Ausführungsbeispielen des Zusammensetzungsprecursors.
Figur 10 zeigt FTIR-Spektren von Ausführungsbeispielen des Zusammensetzungsprecursors.
Figuren 11 bis 14 zeigen ¹H- und ²⁹Si-NMR-Spektren von Ausgangsmaterialien zur Herstellung eines Zusammensetzungsprecursors.
Figuren 15 bis 20, 25 und 26 zeigen ¹H-NMR-Spektren sowie ²⁹Si-¹H HMBC 2D NMR-Spektren von Ausführungsbeispielen des Zusammensetzungsprecursors während und nach seiner Herstellung.
Figuren 21 bis 24 zeigen ¹H-NMR Spektren von Ausführungsbeispielen von Zusammensetzungsprecursoren.
Figur 27 zeigt die schematische Seitenansicht eines Bauelements.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen. Vielmehr können einzelne Elemente, wie zum Beispiel Schichten, Bauteile, Bauelemente und Bereiche zur besseren Darstellbarkeit und/oder zum besseren Verständnis übertrieben groß dargestellt werden.

Zur Herstellung von Ausführungsbeispielen von Zusammensetzungsprecursoren und Zusammensetzungen können beispielsweise folgende Ausgangsmaterialien und Hilfsmittel eingesetzt werden: Dimethyldimethoxysilan (97 %, ABCR GmbH), Methyltrimethoxysilan (97 %, ABCR GmbH), Phenyltrimethoxysilan (97 %, ABCR GmbH), methoxyterminiertes Polydimethylsiloxan (5 bis 12 cst., ABCR GmbH), 1,4-Diazabicyclo[2.2.2]octan (98 % Alpha Aesar, Deutschland), Salzsäure (Bernd Kraft GmbH) und Kaliumhydroxid (85 %, Grüssing GmbH Analytica). Die Salzsäure wird in demineralisiertem Wasser gelöst (pH = 2,3). Kaliumhydroxid wird in Methanol aufgelöst (0,11 mol/l).

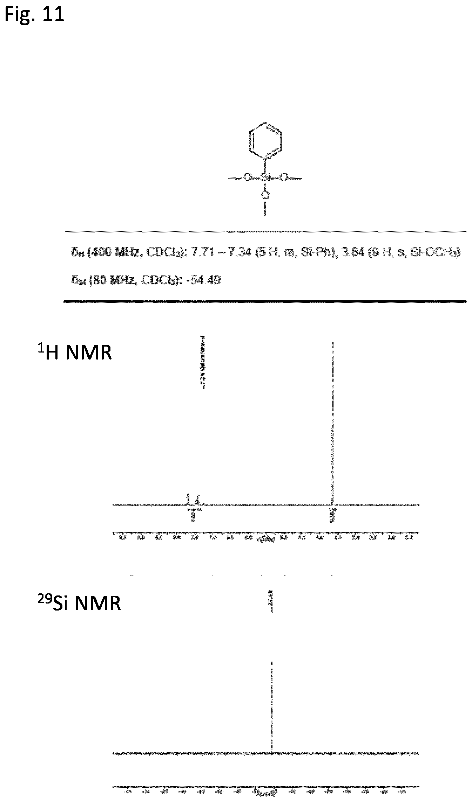

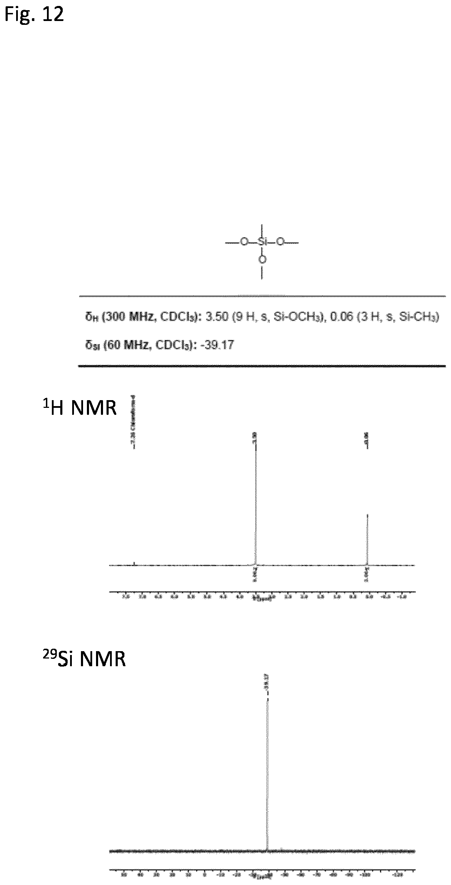

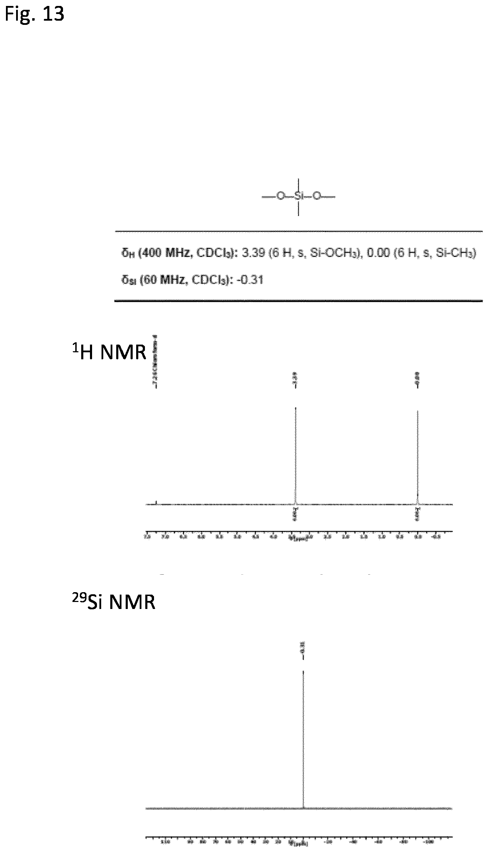

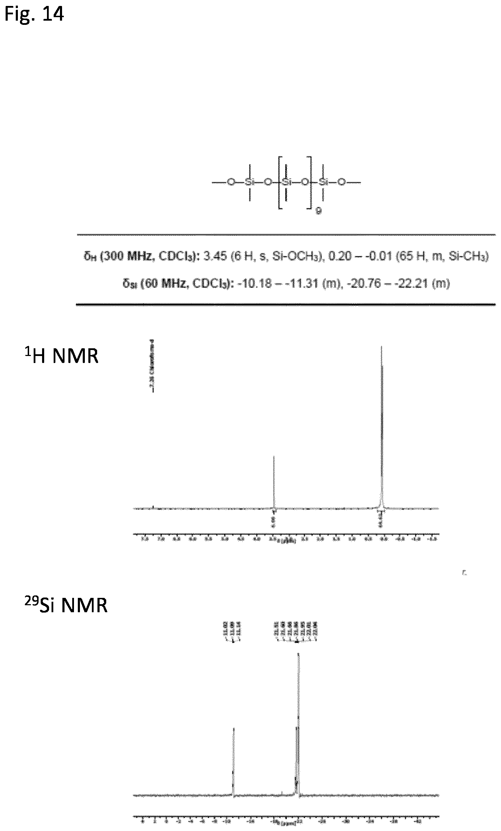

Die Reinheit der Ausgangsmaterialien sowie die mittlere Kettenlänge des methoxyterminierten Polydimethylsiloxans werden mittels ¹H und ²⁹Si NMR-Spektroskopie ermittelt (siehe Figuren 11 bis 14: Figur 11 zeigt die Spektren von Phenyltrimethoxysilan, Figur 12 zeigt die Spektren von Methyltrimethoxysilan, Figur 13 zeigt die Spektren von Dimethyldimethoxysilan und Figur 14 zeigt die Spektren von methoxyterminiertem Polydimethylsiloxan). Die NMR-Spektren wurden mit einem Avance III 300 MHz Spektrometer und einem Avance III HD 400 MHz Spektrometer (Bruker Corp., USA) aufgenommen mit 300,13/400,13 MHz für ¹H-NMR-Spektren und 59,63/79,49 MHz für ²⁹Si-NMR-Spektren. Die zu messenden Proben wurden in Methanol-d4 oder Chloroform-d gelöst.

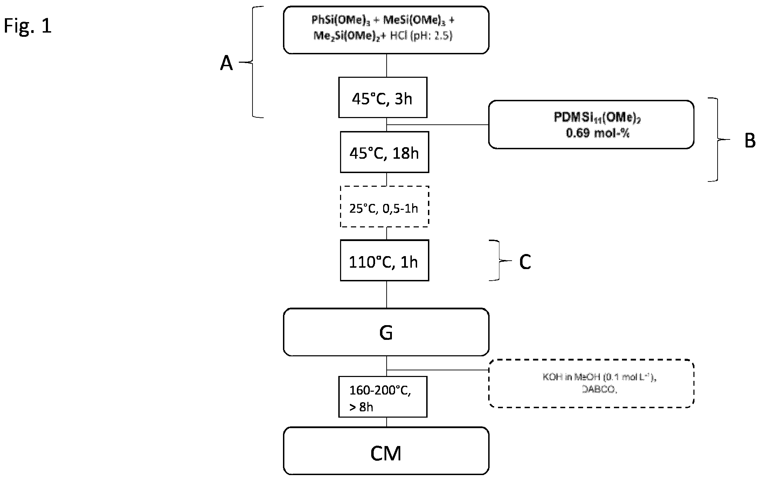

Figur 1 zeigt eine schematische Ansicht der Verfahren zur Herstellung eines Zusammensetzungsprecursors und einer Zusammensetzung anhand eines Ausführungsbeispiels. Zunächst wird zu PhSi(OMe)₃ als TAS, MeSi(OMe)₃ als TAS und Me₂Si(OMe)₂ als DAS Salzsäure mit einem pH von 2,5 zugegeben. Die Salzsäure wird mit einem Anteil von 1,5-mal der Stoffmenge der Alkoxysilane zugegeben. Diese Mischung wird in einem verschlossenen Gefäß bei 45°C für 3 Stunden und bei 320 rpm gerührt. Dies ist in Figur 1 als Verfahrensschritt A) gekennzeichnet. Im Verfahrensschritt B) wird methoxyterminiertes Polydimethylsiloxan PDMSi₁₁(MeO)₂ mit einem Anteil von 0,7 % der Stoffmenge der Alkoxysilane zugegeben und weiter bei 45°C für 18 Stunden bei 320 rpm gerührt. Die Zugabe des PDMSi₁₁(MeO)₂ kann auch gleichzeitig mit dem Verfahrensschritt A) erfolgen (hier nicht gezeigt). Die Mischung wird in einem Becher überführt und bei 25°C für 0,5 bis 1 Stunde bei 150 rpm gerührt. Dieser Gelierungs-Schritt ist optional und daher mit gestrichelten Linien gekennzeichnet. Die Gelierung kann daran erkennt werden, dass homogen verteilte Gasblasen in dem Material entstehen und die Viskosität signifikant ansteigt.

In dem Verfahrensschritt C), dem Reinigungsschritt, wird das Becherglas in einen Trockenschrank überführt und dort bei 110°C für eine Stunde lang Wasser, Salzsäure und Methanol entfernt. Schließlich kann der transparente, gelartige Zusammensetzungsprecursor G isoliert und auf Raumtemperatur abgekühlt werden.

Ein wie oben geschildert erhaltener Zusammensetzungsprecursor kann konsolidiert beziehungsweise gehärtet werden, indem er in eine Form oder Kavität überführt wird und dort bei 150 bis 200°C für 8 bis 72 Stunden gehärtet wird. Die Härtungszeit hängt mit den Anteilen der jeweiligen Ausgangsmaterialien des Zusammensetzungsprecursors und der Dicke der zu härtenden Probe zusammen. Optional kann vor Beginn der Härtung ein kleiner Anteil an Base oder Säure (hier nur Base gezeigt) zu dem Zusammensetzungsprecursor gegeben werden, um die Härtungszeit und Temperatur zu reduzieren. Dieser optionale Schritt ist durch die gestrichelte Linie gekennzeichnet. Die gehärtete Zusammensetzung CM ist frei von Rissen und je nach gewählter Viskosität des Zusammensetzungsprecursors flexibel und elastisch.

In den Verfahrensschritten A) und B) wie in Bezug auf Figur 1 beschrieben, werden die Trialkoxysilane und Dialkoxysilane hydrolisiert und formen ein Oligomer und Polymerketten sowie teilweise quer vernetzte Strukturen. Eine schrittweise Substitution von MeSi(OMe)₃ durch Me₂Si(OMe)₂ führt zu einer mehr kettenartigen und weniger quer vernetzten Struktur. Damit nimmt auch die Viskosität des gebildeten Zusammensetzungsprecursors ab. Das im Verfahrensschritt B) zugegebene Polydimethylsiloxan führt zu einer zusätzlichen Aufweitung des Netzwerks. Wird während dieser Schritte die Temperatur erhöht, erhöht sich gleichzeitig die Viskosität, was den Herstellungsprozess vereinfacht. Durch eine Wärmebehandlung der Zusammensetzungsprecusoren bei Temperaturen von über 150°C wird ein weiterer netzwerkbildender Prozess gestartet. Die gelartigen Zusammensetzungsprecursoren bilden nun ein festes aber elastisches Polymer, die Zusammensetzung CM. Mit diesem Härtungsprozess werden keine Katalysatoren oder andere Komponenten benötigt, um den Zusammensetzungsprecursor zu härten. Es ist jedoch möglich, den Prozess durch Zugabe kleiner Mengen an Base oder Säure zu dem Zusammensetzungsprecursor zu katalysieren. Die Konsolidierungszeit beziehungsweise Härtungszeit und die Temperatur können durch die pH-Abhängigkeit der Kondensierungsreaktion reduziert werden.

Beispielsweise können die Zusammensetzungsprecursoren G für Härtetests in PTFE-Formen der Größe 30x10x1 mm gegeben werden und für Transmissionsmessungen Filme der Größe 13x0,12 mm auf Glasplatten hergestellt werden. Die im Folgenden noch näher spezifizierten Beispiele 1 und 2 wurden dafür für eine bessere Handhabbarkeit auf 110°C erhitzt. Zur Filmherstellung kann der Quadrupel Film Applicator Model-360 (Erichsen GmbH & Co. KG) verwendet werden. Die Dicke der Filme kann mit einer FMD12TB Präzisionsmessuhr (Käfer Messuhrenfabrik GmbH & Co. KG) mit einer Genauigkeit von 1 µm gemessen werden. Die derartig vorbereiteten Proben können beispielsweise bei 200°C für 72 Stunden in einem Trockenschrank gehärtet werden. Die transparenten Zusammensetzungen CM werden dann auf Raumtemperatur gekühlt und isoliert.

Tabelle 1 zeigt die genauen Anteile der Ausgangsmaterialien der Zusammensetzungsprecursoren gemäß den Beispielen 1 bis 8:

**Tabelle 1**

| | n[PhSi(OMe)₃] | n[MeSi(OMe)₃] | n[Me₂Si(OMe)₂] | n[PDMSi₁₁-(MeO)₂] | Ph[calc.)/Ph[¹H NMR]* | TAS** | DAS** | PDMS** |
|---|---|---|---|---|---|---|---|---|
| Sample | mmol | mmol | mmol | mmol | % | % | % | % |
| 1 | 25.23 | 22.69 | 2.62 | 0.35 | 41.49/42.6 | 94.17 | 5.14 | 0.68 |
| 2 | 25.27 | 20.07 | 5.12 | 0.36 | 39.96/39.6 | 89.24 | 10.08 | 0.68 |
| 3 | 25.23 | 15.01 | 10.20 | 0.35 | 36.94/34.9 | 79.22 | 20.09 | 0.68 |
| 4 | 25.21 | 12.83 | 12.72 | 0.35 | 35.43/33.1 | 74.43 | 24.89 | 0.68 |
| 5 | 25.06 | 9.98 | 15.23 | 0.35 | 34.26/31.3 | 69.23 | 30.09 | 0.68 |
| 6 | 25.21 | 8.71 | 16.57 | 0.37 | 33.74/30.3 | 66.72 | 32.59 | 0.68 |
| 7 | 25.23 | 7.49 | 17.75 | 0.35 | 33.25/29.9 | 64.38 | 34.93 | 0.68 |
| 8 | 25.21 | 4.93 | 20.35 | 0.35 | 32-11/28.8 | 59.28 | 40.03 | 0.68 |

Es wurden acht Zusammensetzungsprecursoren (in Tabelle 1 mit Sample 1 bis 8 bezeichnet) hergestellt. In Tabelle 1 werden die Stoffmengen n der jeweiligen Ausgangsmaterialien angegeben, sowie die Anteile der summierten Trialkoxysilane TAS, der Dialkoxysilane DAS und des Polydimethylsiloxans PDMS in mol%. Weiterhin wird der Anteil an Phenylgruppen Ph [calc.]/Ph [¹H NMR] angegeben, der in Bezug auf die Gesamtanzahl an Alkyl- und Arylgruppen zu sehen ist. Dabei wird der berechnete Anteil der eingewogenen Mengen durch den berechneten Anteil aus der Integration der NMR-Spektren geteilt.

Während der Anteil von PhSi(OMe)₃ und PDMSi₁₁(MeO)₂ konstant gehalten wurde, wird in den Beispielen 1 bis 8 der Anteil von MeSi(OMe)₃ schrittweise durch Me₂Si(OMe)₂ ersetzt. Diese Substitution eines Methyltrialkoxysilans durch ein Dimethylalkoxysilan führt zu einer aufgeweiterten und weniger quer vernetzten Struktur des resultierenden Zusammensetzungsprecursors und damit auch der gehärteten Zusammensetzung (CM). Dadurch resultiert eine deutlich verminderte Viskosität der Zusammensetzungsprecursoren beziehungsweise Härte der Zusammensetzungen. Gleichzeitig erhöht sich der Brechungsindex durch das größere Verhältnis von Phenyl- zu Methylgruppen.

Im Folgenden wird auf die Beispiele 1 bis 8 weiterhin Bezug genommen. Wenn die Zusammensetzungen gemeint sind, die aus den jeweiligen Zusammensetzungsprecursoren hergestellt sind, wird die Nummerierung 1 bis 8 beibehalten und der Zusatz CM hinzugefügt.

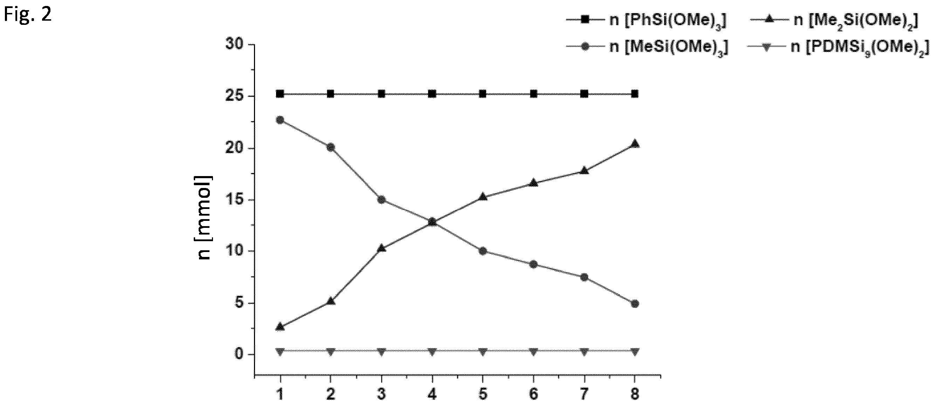

Figur 2 zeigt die Stoffmengen n in mmol der eingesetzten Ausgangsmaterialien in den Beispielen 1 bis 8 (x-Achse). Hier ist wieder deutlich zu erkennen, dass der Anteil von PhSi(OMe)₃ und PDMSi₁₁(MeO)₂ in allen Beispielen konstant gehalten wurde (Quadrat und nach unten zeigendes Dreieck), während die Anteile von MeSi(OMe)₃ (Kreis)und Me₂Si(OMe)₂ (nach oben schauendes Dreieck) verändert wurden. Insbesondere ist die Substitution von MeSi(OMe)₃ durch Me₂Si(OMe)₂ zu erkennen.

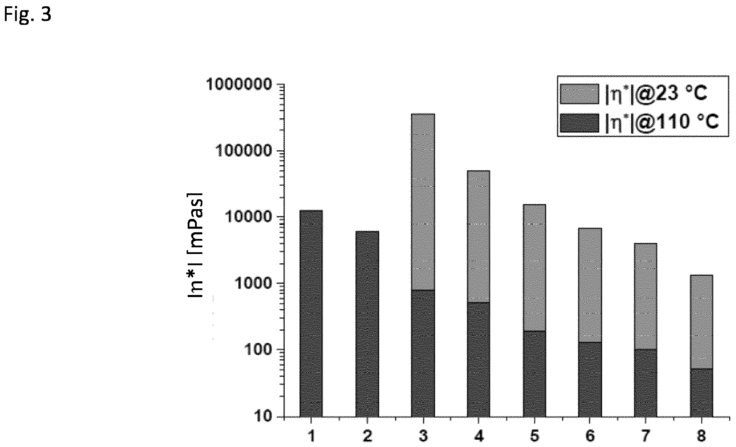

Die absoluten Werte der Viskositäten wurden mit einem MCR-301 Rheometer mit einem CTD-450 Konvektionsheizsystem (Anton Paar GmbH, Österreich) oszillatorisch mit einer Platte-Platte Geometrie (25 mm PP25 Messplatte), einer Amplitude von 5%, einer Frequenz von 1 Hz und einer Normalkraft von 0 gemessen. Figur 3 zeigt die gemittelten absoluten Werte der Viskosität der Proben 1 bis 8, die isotherm bei 23°C und bei 110°C jeweils für 10 Minuten gemessen wurden. Die absoluten Werte der Viskosität bei Raumtemperatur (|η*|@23°C in mPas) und bei 110°C (|η*|@110°C in mPas) können direkt nach der Synthese der Zusammensetzungsprecusoren bestimmt werden. Sie sinkt von Beispiel 1 bis 8, also mit Zunahme des substituierten Gehalts von MeSi(OMe)₃ durch Me₂Si(OMe)₂, wie in Figur 3 gezeigt ist. Die Viskosität der Beispiele 1 und 2 ist zu hoch, um bei Raumtemperatur gemessen zu werden. Beim Erwärmen der Proben auf 110°C nimmt der absolute Wert der Viskosität signifikant ab. Alle Beispiele können einfach bei 110°C prozessiert werden. Die Proben 3 bis 8 können aufgrund ihrer Viskosität auch bei Raumtemperatur verarbeitet werden, das macht die Materialien zum Beispiel als härtbares Verkapselungsmaterial für optoelektronische Bauelemente geeignet.

Werden die Zusammensetzungsprecursoren gelagert und somit einem Alterungsprozess unterworfen, kann ihre Viskosität mit der Lagerzeit bei Raumtemperatur steigen. Werden beispielsweise Proben des Beispiels 4 nach 60 Tagen der Lagerung untersucht, kann gezeigt werden, dass die Viskosität von 50 Pas auf 420 Pas steigt. Diese Alterung wird durch das immer noch flexible Netzwerk des Zusammensetzungsprecursors erzeugt, die den Si-OMe- und Si-OH-Gruppen weitere Kondensationsreaktionen ermöglicht. Die Alterung kann vermieden oder zumindest vermindert werden, wenn die Proben bei niedrigerer Temperatur gelagert werden. Die gealterten Zusammensetzungsprecursoren können jedoch immer noch verarbeitet werden, da sie bei Temperaturen über 23°C weicher werden.

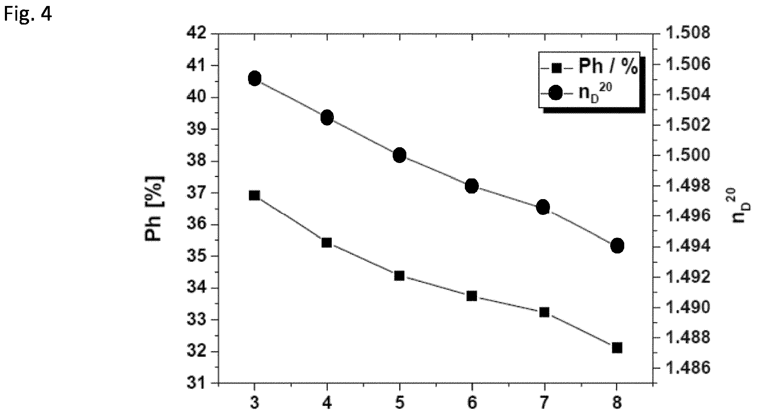

Werden die Zusammensetzungsprecursoren dazu verwendet, in Verkapselungen von optoelektronischen Bauelementen eingesetzt zu werden, ist es wichtig, dass sie einen definierten und vorzugsweise hohen Brechungsindex aufweisen. Hohe Brechungsindizes in Zusammensetzungsprecursoren (und damit auch in den daraus gehärteten Zusammensetzungen) können durch das Vorhandensein von mono- oder polyzyklischen aromatischen Seitengruppen begünstigt werden. In den Proben 3 bis 8 ändert sich der Anteil von Phenylgruppen von 37% zu 32%, wie in Figur 4 (linke y-Achse) gezeigt ist. Gleichzeitig ändert sich der Brechungsindex n_{D}²⁰ von 1,505 nach 1,494 (rechte y-Achse). Der Brechungsindex kann beispielsweise mit einem AR4 Abbe Refraktometer mit einem PT31 Peltier Thermostat (A. Krüss Optronic GmbH) bei 20°C und 590 nm LED Bestrahlung gemessen werden. Durch die schrittweise Substitution von MeSi(OMe)₃ durch Me₂Si(OMe)₂ nimmt der Anteil der Phenylgruppen in den Proben ab, womit auch der Brechungsindex sinkt. Das zeigt, dass der Abfall des Brechungsindexes direkt korreliert mit dem Anteil an Phenylgruppen in den Proben. Der Brechungsindex der Proben 1 und 2 konnte aufgrund ihrer sehr hohen Viskosität bei 20°C nicht bestimmt werden.

Die Werte für die Brechungsindizes zwischen 1,505 und 1,494 der Zusammensetzungsprecusoren sind hoch genug für die Anwendung in optoelektronischen Bauelementen.

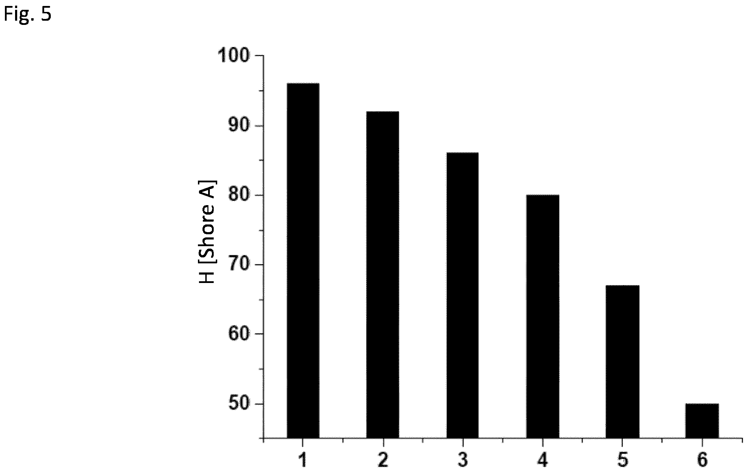

Durch die Substitution von MeSi(OMe)₃ durch Me₂Si(OMe)₂, also dem Anteil der Phenylgruppen in den Zusammensetzungsprecursoren, kann weiterhin die Härte der zugehörigen Zusammensetzungen eingestellt werden, an die je nach Anwendung unterschiedliche Anforderungen bestehen können. Die Härte der konsolidierten Zusammensetzungen kann bei Raumtemperatur mit einem Shore-A-Durometer gemessen werden. Dazu können einzelne Probenplättchen übereinandergelegt werden, um die dafür minimal erforderliche Dicke zu erreichen. Figur 5 zeigt die Härte H in Shore-A für die Beispiele 1 CM bis 6 CM, die mit zunehmendem Anteil von Me₂Si(OMe)₂ und mit zunehmender Temperatur abnimmt. Die Proben 7 CM und 8 CM waren zu weich für eine Härtebestimmung. Ein höherer Anteil von Me₂Si(OMe)₂ führt zu längeren und weniger quer vernetzten Polymerketten. Diese Aufweitung einer zuvor engmaschigen Struktur führt zu der Abnahme der Härte der Zusammensetzungen.

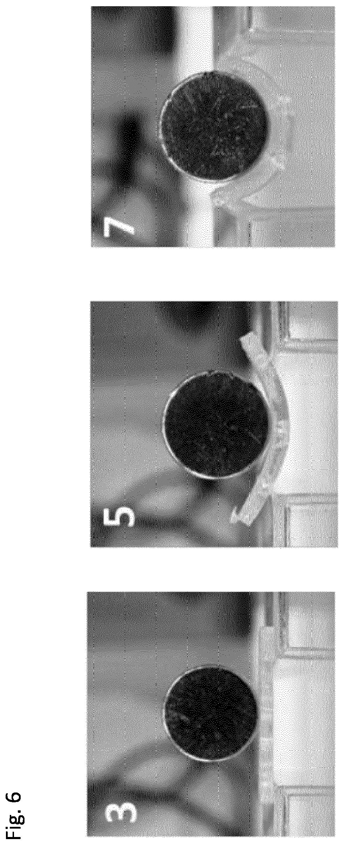

Die abnehmende Härte unter den Proben 3, 5 und 7 ist auch in Figur 6 dargestellt, in der Abbildungen zu sehen sind, bei denen jeweils ein 1,9 g schwerer Magnet auf ein Probenplättchen gelegt wurde. Bei dem Plättchen aus einer Zusammensetzung gemäß Beispiel 3 CM führt das zu keiner Verbiegung, gemäß Beispiel 7 CM zu einer starken Verbiegung.

Für die Anwendungen in optoelektronischen Bauelementen ist eine hohe Transparenz des Verkapselungsmaterials erforderlich. In weißen LEDs wird beispielsweise das gesamte sichtbare Spektrum von Licht emittiert. Für eine vergleichbare Transmissionsmessung werden alle Proben der Zusammensetzungsprecursoren zu einem Polymerfilm verarbeitet, der auf Glasplättchen mittels eines Filmapplikators (13 x 0,12 mm) aufgebracht wird. Dadurch sind alle Proben einheitlich, ohne Einschlüsse oder Blasen und haben eine gleichmäßige Dicke. Diese Proben werden in einem Trockenschrank bei 200°C für 72 Stunden gehärtet. Durch den Konsolidierungsprozess schrumpfen die Proben. Die tatsächliche Filmdicke wurde an drei verschiedenen Stellen für jede Probe bestimmt, bevor die Probe mittels UV/VIS (Lambda 750 von Perkin Elmer Inc., USA, mit einem 100 mm Integrationsbereich von 700 bis 350 nm mit einem 2 nm Inkrement und 0,2 s Integrationszeit) gemessen wurde. Die Filmdicke für die Probe 1 CM beträgt 81 ± 1 µm, für die Probe 2 CM 61 ± 2 µm, für die Probe 3 CM 51 ± 5 µm, für die Probe 4 CM 95 ± 8 µm, für die Probe 5 CM 63 ± 2 µm, für die Probe 6 CM 48 ± 2 µm, für die Probe 7 CM 42 ± 2 µm, und für die Probe 8 CM 35 ± 5 µm. Alle Proben zeigen Transmissionswerte von über 0,99 zwischen 350 und 730 nm direkt nach dem Härtungsprozess. Die Schrumpfung der Proben scheint nicht systematisch zu sein. Die hohe Transparenz ist optimal für die Anwendung in optischen Anwendungen jeglicher Art, insbesondere in optoelektronischen Bauelementen.

Verkapselungsmaterialien für optoelektronische Bauelemente müssen gießbar, härtbar und dicht sein. Wird ein Zusammensetzungsprecursor als Verkapselungsmaterial in einem Bauelement angeordnet und anschließend zu einer Zusammensetzung gehärtet, muss diese frei von Rissen und Blasen sein sowie eine gewisse Elastizität aufweisen. Um die Einsetzbarkeit der Zusammensetzungsprecusoren in optoelektronischen Bauelementen zu demonstrieren, wurden die Proben 4 und 6 auf einem Polyphtalamid LED Leiterrahmen (1,4 x 0,7 x 0,4 mm) gegossen und die Leiterahmen zur Härtung der Zusammensetzungsprecursoren bei 160°C für 20 Stunden wärmebehandelt.

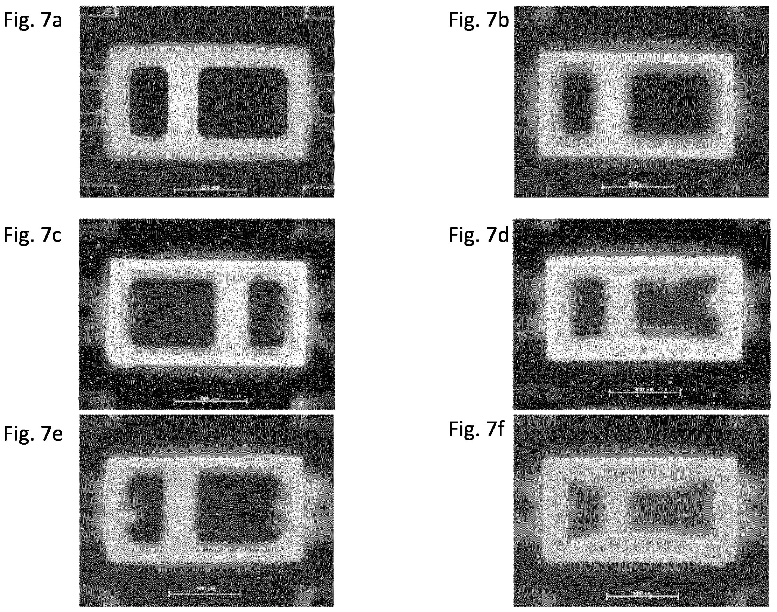

Figuren 7a bis f zeigen Abbildungen des leeren Leiterrahmens (Figuren 7a und b), des Leiterrahmens mit einem Zusammensetzungsprecursor des Beispiels 4 und einer Zusammensetzung 4 CM (Figuren 7c und d) sowie einen Leiterrahmen mit einem Zusammensetzungsprecursor des Beispiels 6 und einer Zusammensetzung 6 CM (Figuren 7e und f). Das Bild in Figur 7a ist auf den metallischen Untergrund fokussiert, in Figur 7b auf die obere Kante des Leiterrahmens. In Figur 7c wird der farbige Eindruck durch die metallische Basisplatte erzeugt, dasselbe gilt für die Figur 7d. Die in Figur 7e sichtbaren Blasen, die durch das Auftragen des Zusammensetzungsprecursors erzeugt wurden, verschwinden nach dem Härtungsprozess, wie in Figur 7f zu sehen ist. Beide gegossenen Zusammensetzungsprecusoren 4 und 6 zeigen eine sehr gute Verarbeitbarkeit. Nach der Härtung können keine Blasen oder Risse innerhalb der Zusammensetzungen 4 CM und 6 CM gemessen werden. Anhand der Seitenränder der Leiterrahmen als Referenz vor und nach der Härtung kann eine Schrumpfung der Materialien erkannt werden. Insgesamt eignen sich die Zusammensetzungsprecusoren und damit auch die Zusammensetzungen gut für Verkapselungsmaterial für LED-Anwendungen.

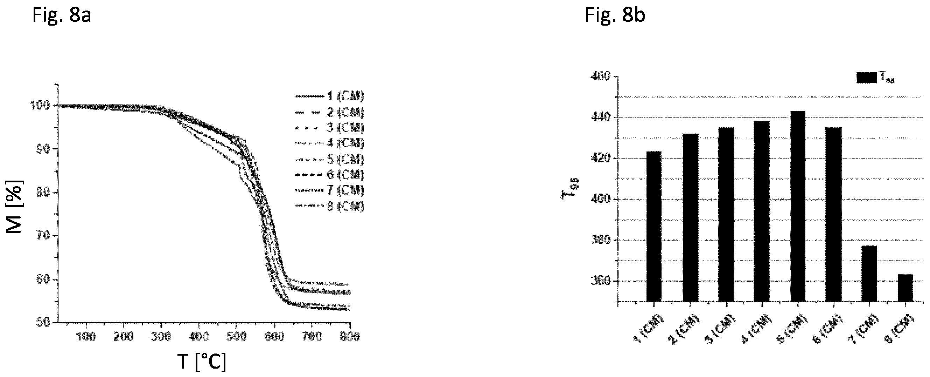

Eine weitere wichtige Eigenschaft in verschiedenen Anwendungen von Zusammensetzungsprecursoren und Zusammensetzungen, unter anderen in LED-Anwendungen, ist eine hohe Temperaturstabilität des Materials. Unter Arbeitsbedingungen in einer LED kann die lokale Temperatur auf über 150°C steigen. Daher wurden die gehärteten Zusammensetzungen auf 800°C mit einer Heizrate von 10 K/min und unter N₂/O₂ mit einem Gasfluss von 20 ml/min aufgeheizt (mit einem TG209 F1 Libra thermo-microbalance von Netzsch-Gerätebau GmbH), um ihr Zersetzungsverhalten zu messen, was in Figur 8 zu sehen ist. Die Temperatur, bei der 95% der Masse der Probe nach Zersetzung übrig ist, wird als T₉₅-Wert definiert. Je höher der T₉₅-Wert ist, desto hitzestabiler ist die Zusammensetzung. In Figur 8a ist der thermographimetrische Masseverlust der Beispiele 1 CM bis 8 CM gezeigt. Aufgetragen ist die Masse M in % gegen die Temperatur T in °C. Alle Proben zeigen eine hohe thermische Stabilität bis 400°C. Figur 8b zeigt für die Zusammensetzungen 1 CM bis 8 CM erhaltenen T₉₅-Werte. Dieser liegt für alle Proben bei über 360°C, was sie geeignet macht für Anwendungen, bei denen hohe Arbeitstemperaturen herrsche. Bei unter 200°C wird keine Zersetzung der Proben gemessen. Auch das zeigt eine sehr hohe thermische Stabilität der Proben an.

Wie oben bereits erwähnt kann der Härtungsprozess zur Herstellung der Zusammensetzung durch die Zugabe kleiner Mengen einer Base oder Säure zu dem Zusammensetzungsprecursor katalysiert werden. Die Base kann beispielsweise direkt vor der Wärmebehandlung der Zusammensetzungsprecusoren zugegeben werden. Beispielsweise können KOH und DABCO als Basen verwendet werden. Um die Veränderung der Viskosität zu zeigen wurde in einem Zusammensetzungsprecursor des Beispiels 4, der 60 Tage gealtert war, die Viskosität isothermisch bei 110°C nach Zugabe unterschiedliche Mengen an KOH gemessen. In der Probe 4-M0 wurde kein KOH zugegeben, in der Probe 4-M1 wurden 5,5 mmolg⁻¹ und zu der Probe 4-M2 13,9 mmolg⁻¹ zugegeben. Dazu wurde Kaliumhydroxid (0,093 g, 1,65 mmol) in Methanol (14,949 ml, 0,369 mol, 0,11 mol/l) aufgelöst. Von dieser Lösung wurden die Mengen 0,0, 1,0 und 2,5 µl zu den Proben des Beispiels 4 (0,2 g) gegeben und gemischt.

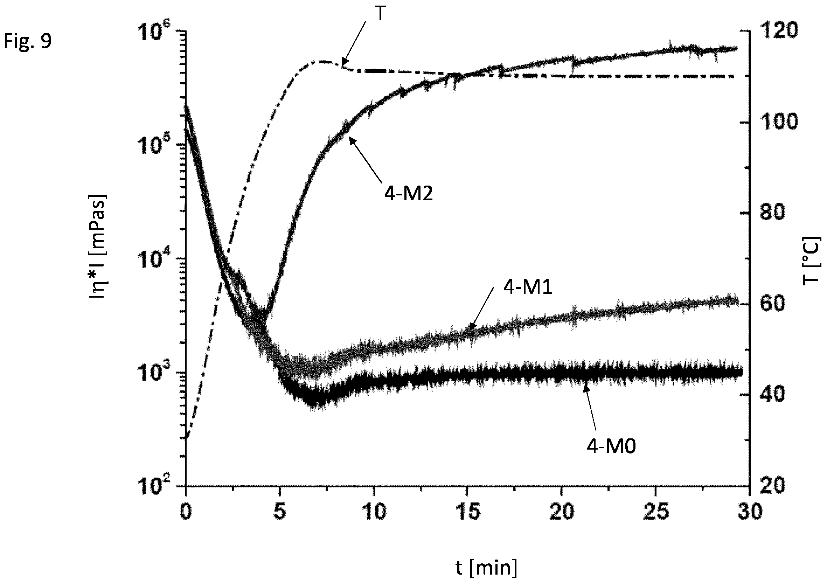

Alle drei Beispiele zeigen einen Abfall der Viskosität |η*| mit anfänglichen Anstieg der Temperatur T. Die Proben 4-M1 und 4-M2 zeigen einen signifikanten Anstieg der Viskosität bei 110°C während die Viskosität von 4-M0 beinahe konstant bleibt. Damit ist der Anstieg der Viskosität direkt korreliert mit dem Anteil an KOH, der zu den Proben zugegeben wurde. Diese Zusammenhänge sind in Figur 9 gezeigt, bei der auf der X-Achse die Zeit t in min, der linken Y-Achse die Viskosität |η*| in mPas und auf der rechten Y-Achse die Temperatur T in °C angegeben sind. Die Viskosität wurde mit einem Oszillationsrheometer bei 5 K/min und einer Amplitude von 5% bei einer Frequenz von 1 Hz und einer Normalkraft von 0 N beginnend bei 110°C gemessen. Es kann somit gezeigt werden, dass die Härtungszeit und -temperatur für jeden Bedarf angepasst werden kann, indem die Menge an zugegebener Base entsprechend ausgewählt wird. Die Härtungstemperatur muss für jede Zusammensetzung optimiert werden, um zu vermeiden, dass sich Blasen beispielsweise aufgrund von Methanolbildung bilden. Wenn die Zusammensetzung zu schnell härtet, verbleiben Blasen darin. Eine Vorbehandlung unter reduziertem Druck vor dem Vergießen des Zusammensetzungsprecursors kann Lösungsmittelrückstände entfernen. Wird eine schwächere Base ohne Lösungsmittel verwendet, beispielsweise DABCO (pK_{b} = 5,2) kann die Bildung von Blasen ebenfalls vermieden oder vermindert werden.

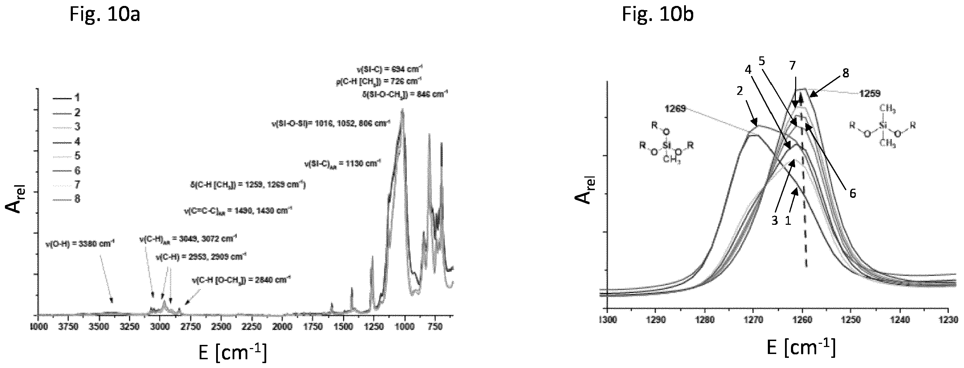

Alle Proben zeigen die erwarteten Schwingungsbanden bei Messungen mittels FTIR-Spektroskopie (gemessen in Totalreflexion-Modus mit einem Vertex 70 Spektrometer von Bruker Corp., USA von 4500 bis 400 cm⁻¹ mit einem 4 nm Inkrement und 10 gemittelten Scans). Die FTIR-Spektren der Beispiele 1 bis 8 sind in Figur 10a gezeigt, wo die relative Absorption Aᵣₑₗ in Abhängigkeit der Energie E in cm⁻¹ angegeben ist. Damit kann auch die schrittweise Substitution der Methyltrimethoxisilane durch Dimethyldimethoxisilane gezeigt werden. Durch die Substitution nimmt die Intensität der Bande bei 1269 cm⁻¹ ab, während die Intensität bei der Bande bei 1259 cm⁻¹ steigt. In Figur 10b ist ein vergrößerter Ausschnitt des FTIR-Spektrums der Beispiele 1 bis 8 gezeigt, der die Abnahme der Schwingungsbande bei 1269 cm⁻¹ zeigt, der durch den abnehmenden Anteil MeSi(OMe)₃ in den Beispielen verursacht ist. Weiterhin ist der Anstieg der Schwingungsbande bei 1259 cm⁻¹ gezeigt, der durch einen steigenden Gehalt an Me₂Si(OMe)₂ verursacht wird.

Das Kondensationsverhalten verschiedener Monomereinheiten, die in der Synthese des Zusammensetzungsprecursors verwendet werden, kann mittels zweidimensionaler ²⁹Si-¹H Kernresonanzspektroskopie (2D-NMR) verfolgt werden. Die Ergebnisse eines heteronuklearen Mehrfachbindungskorrelationsexperiment (HMBC) der Zusammensetzungsprecursoren 1, 2, 3 und 8 sind in folgender Tabelle 2 gezeigt. Zur Durchführung des Experiments wurden kleine Mengen der Proben der jeweiligen Reaktionsmischung nach 3 Stunden der Hydrolyse (vor der Zugabe des PdMSi₁₁(MeO)₂) und nach abgeschlossener Synthese der jeweiligen Zusammensetzungsprecursoren entnommen. Es werden jeweils Bereiche der Peaks angegeben, da eine hohe Konzentration verschiedener Arten von Molekülen (hydrolisierte und nicht-hydrolisierte Moleküle, Monomere, Oligomere, polymere, Ringe etc.) vorliegt, welche die ²⁹Si-chemischen Shifts sehr breit und die Auflösung daher schwierig machen.

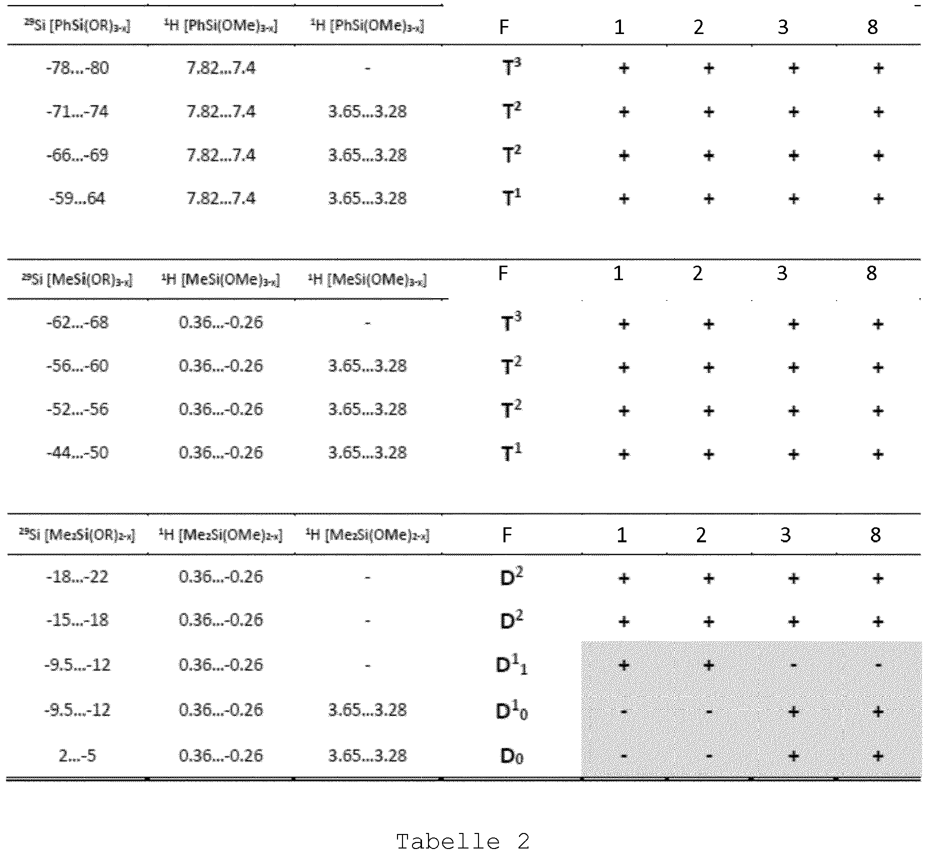

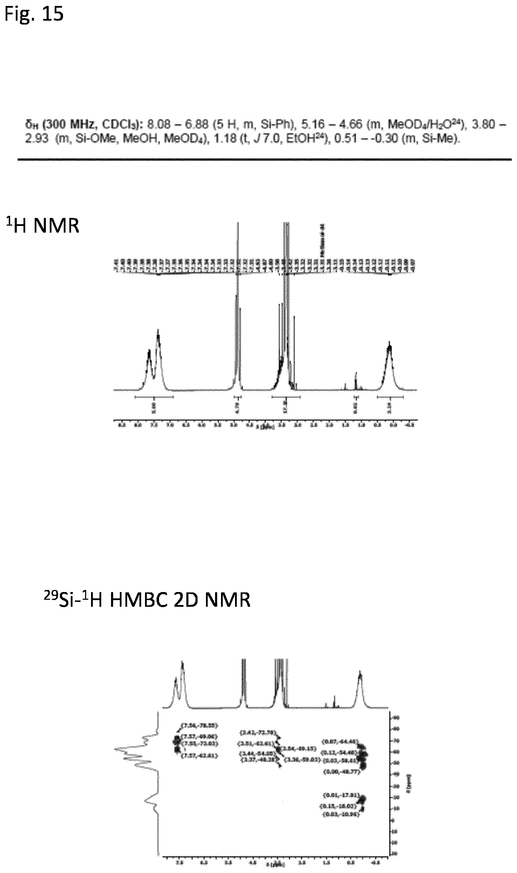

Die zugehörigen Spektren zusammen mit den ¹H-NMR-Spektren der übrigen Beispiele der Zusammensetzungsprecursoren sind in den Figuren 15 bis 26 gezeigt.

Dabei zeigen:

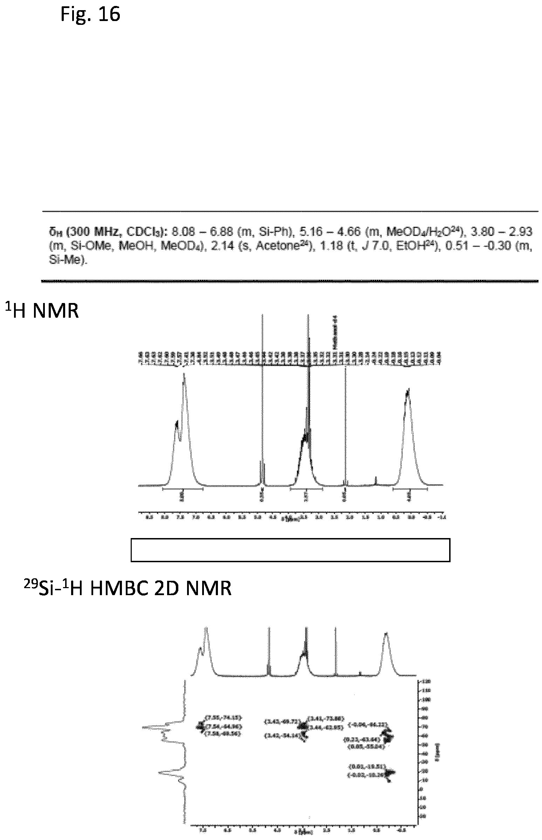

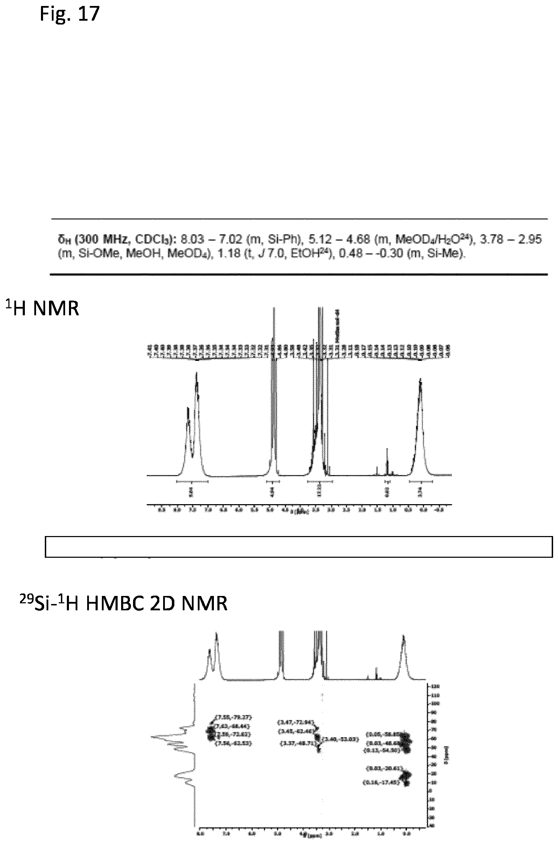

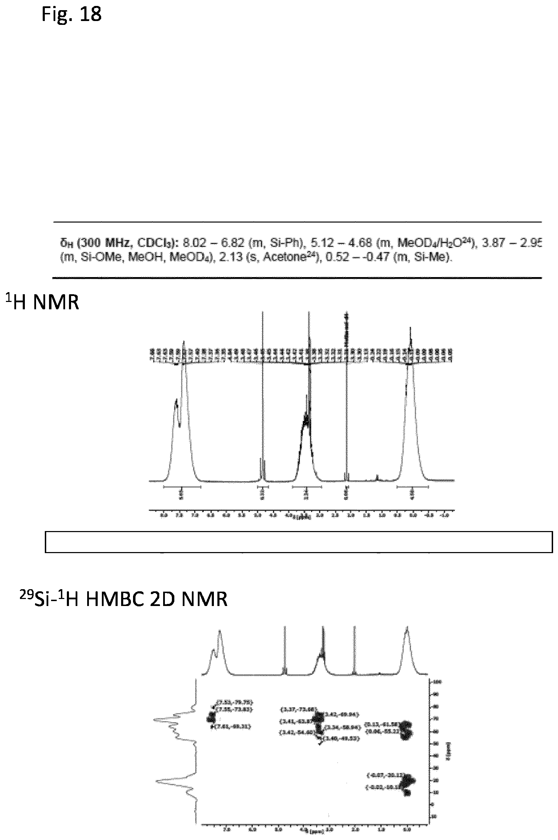

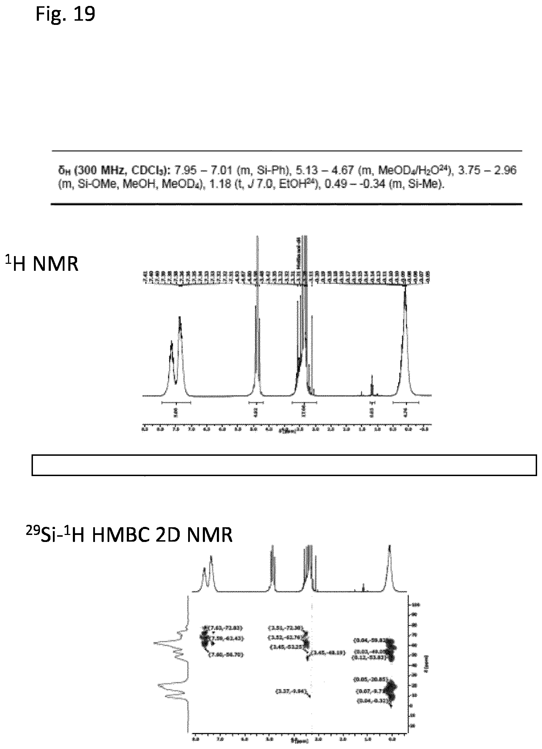

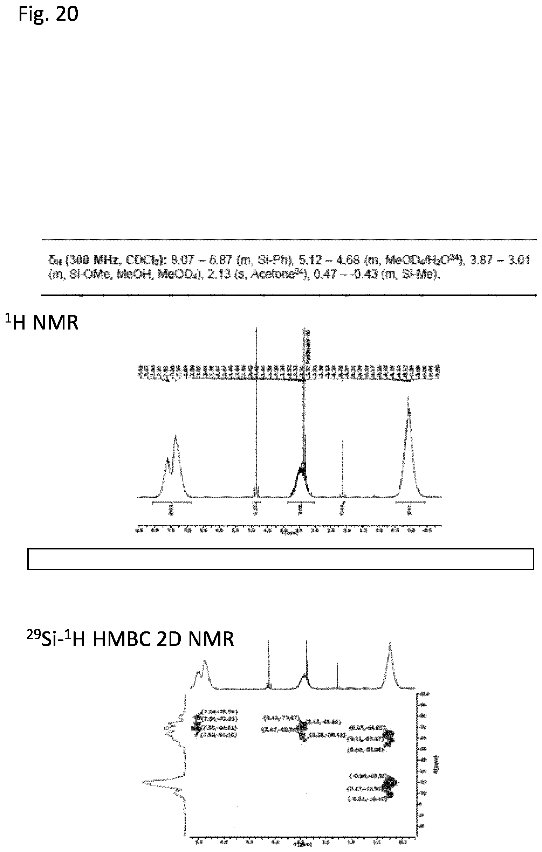

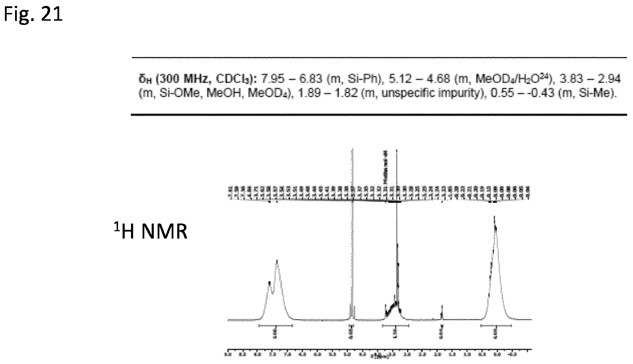

Figur 15: Probe 1 nach 3h, Figur 16: Probe 1 nach der Synthese, Figur 17: Probe 2 nach 3h, Figur 18: Probe 2 nach der Synthese, Figur 19: Probe 3 nach 3h, Figur 20: Probe 3 nach der Synthese, Figur 21: ¹H-NMR-Spektrum der Probe 4,

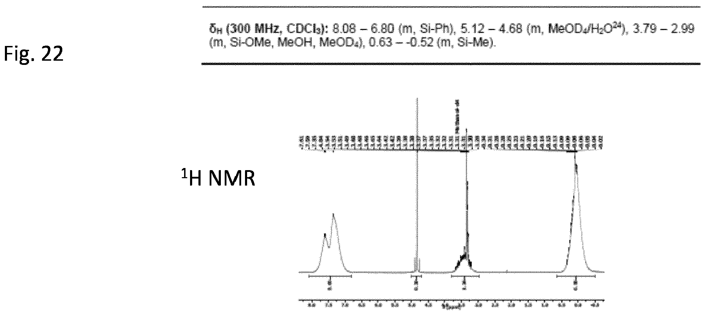

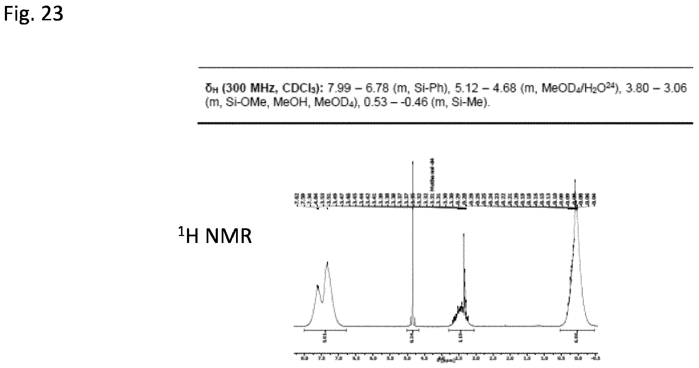

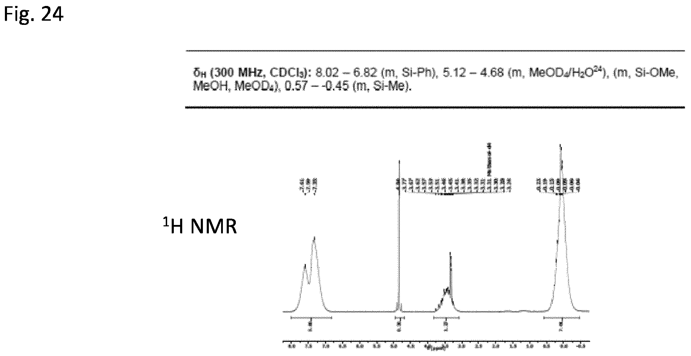

Figur 22: ¹H-NMR-Spektrum der Probe 5, Figur 23: ¹H-NMR-Spektrum der Probe 6, Figur 24: ¹H-NMR-Spektrum der Probe 7,

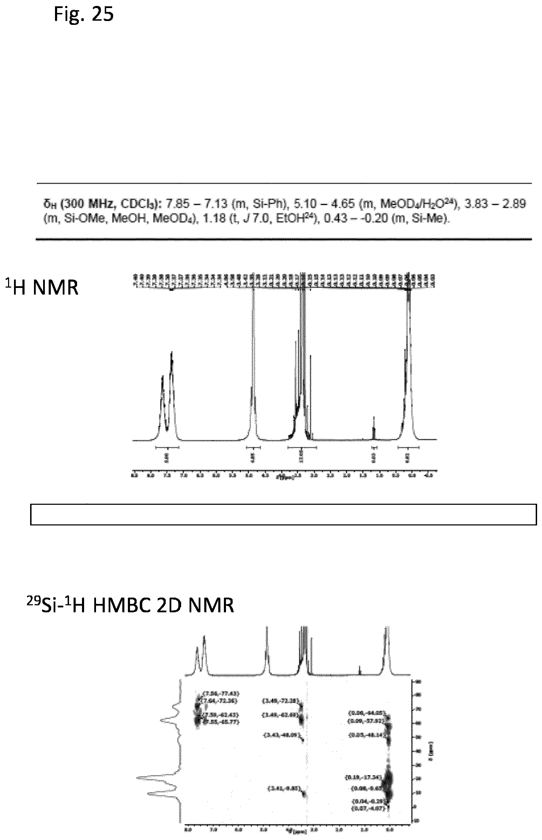

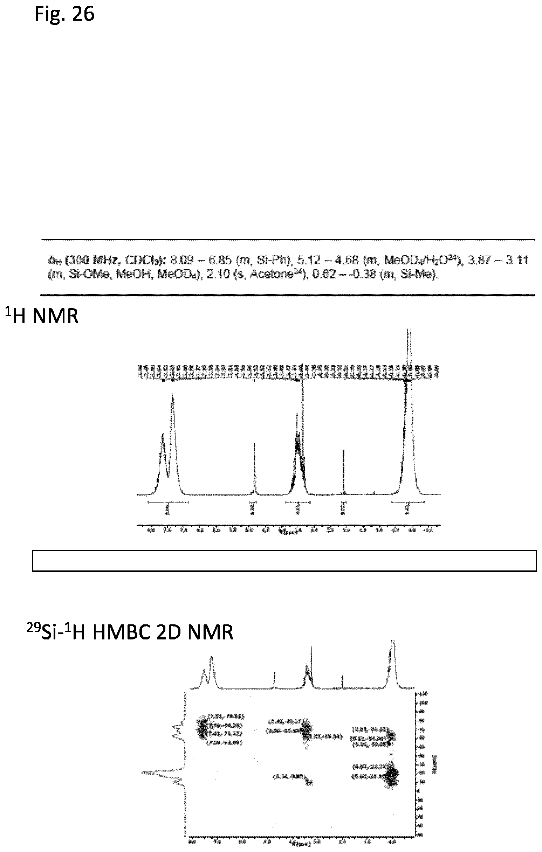

Figur 25: Probe 8 nach 3h, Figur 26: Probe 8 nach der Synthese.

Die Spektren der Proben 1, 2, 3 und 8 zeigen die möglichen chemischen Verschiebungen der trifunktionalen T-Einheit außer T⁰ (siehe auch Tabelle 2, in der die funktionellen Gruppen F angegeben sind). Das zeigt, dass die Phenyltrimethoxysilan-Monomere und Methyltrimethoxysilan-Monomere mindestens einmal mit einem zweiten Molekül oder einem Teil einer linearen oder quervernetzten Struktur reagiert haben. Zusätzlich scheint es, dass jedes T-Signal außer T³ mit der chemischen Verschiebung der Methoxygruppen gekoppelt ist. Daraus kann man schließen, dass signifikant wenig trifunktionelle Moleküle hydrolisiert wurden, bevor sie mit anderen Molekülen reagiert haben.

Die chemischen Verschiebungen, die durch difunktionelle D-Einheiten von Me₂Si(OMe)₂-Gruppen verursacht werden, zeigen ein unterschiedliches Verhalten. In den Proben 1 und 2 können keine unreagierten D⁰-Signale detektiert werden. Alle Monomere reagierten mindestens einmal mit einem zweiten Molekül oder einen Teil einer linearen oder quervernetzten Struktur, wie durch die beobachteten D¹- und D²-Signale beobachtet werden kann. Die D¹-Signale können in D¹₀₋ und D¹₁-Signale aufgeteilt werden. Die indizierten Zahlen zeigen den Anteil der Hydroxylgruppen, die an ein Molekül gebunden sind, an. Ein D¹₀- Signal wird durch ein Monomer mit keiner Hydroxylgruppe erzeugt, ein D¹₁-Signal wird durch ein Monomer mit einer Hydroxylgruppe erzeugt. Das zusätzliche D¹₁-Signal kann durch die chemische Verschiebung separiert werden und ist messbar, da keine Kopplung mit den Methoxygruppen besteht. In den Spektren der Proben 3 und 8 können auch D¹-Signale der Endgruppen und D²-Signalen von linearen oder quervernetzten Einheiten beobachtet werden. D⁰-Signale können an unreagierten Monomeren gemessen werden. Die Reaktion scheint nach drei Stunden Rühren noch nicht beendet zu sein. Somit reagieren TAS-Monomere miteinander und mit DAS-Monomeren, wobei gerade und quervernetzte Strukturen gebildet werden. Bei Erhöhung der DAS-Konzentration nimmt die Anzahl nicht-reagierter DAS-Monomere zu, während die Anzahl nicht-reagierter TAS-Monomere in jeder Probe 0 ist. Daraus kann man schließen, dass die Kondensationsreaktion zwischen TAS- und DAS-Monomeren im Vergleich zu einer Reaktion zwischen zwei DAS-Molekülen bevorzugt ist. Nach weiteren Syntheseschritten sind keine D⁰-Signale mehr messbar. Die Monomere haben mit den zuvor gebildeten Strukturen reagiert.

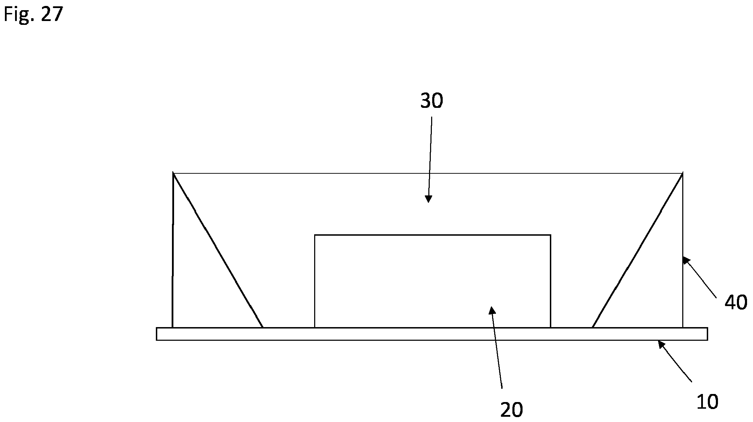

Figur 27 zeigt die schematische Seitenansicht eines optoelektronischen Bauelements gemäß eines Ausführungsbeispiels. Das Bauelement, beispielsweise eine LED umfasst ein Substrat 10, auf dem eine Halbleiterschichtenfolge 20 angeordnet ist. Die Halbeiterschichtenfolge 20 ist zur Emission von Primärstrahlung, beispielsweise kurzwelliges Licht mit einem Wellenlängenmaximum von etwa 450 nm, eingerichtet.

Im Strahlengang der Primärstrahlung ist eine Konversionsschicht 30 angeordnet. Diese umhüllt die Halbleiterschichtenfolge 20 vollständig, das heißt stoff- und formschlüssig, und ist somit als Verguss in einer Ausnehmung des Gehäuses 40 eingebracht. Damit dient die Konversionsschicht 20 zum einen als Verkapselung der Halbleiterschichtenfolge 20, zum anderen zur Konversion der Primärstrahlung in eine Sekundärstrahlung. Die Konversionsschicht enthält einen Farbstoff, der in einer Matrix, welche aus einer Zusammensetzung gebildet ist, eingelagert ist.

Alternativ kann die Konversionsschicht 30 beabstandet zu der Halbleiterschichtenfolge 20 angeordnet sein (hier nicht gezeigt). In diesem Fall kann zwischen der Halbleiterschichtenfolge 20 und der Konversionsschicht 30 eine Verkapselung, die aus der Zusammensetzung gebildet ist, angeordnet sein.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen was insbesondere jede Kombination von Merkmalen in den Patentansprüchen beinhaltet, auch wenn dieses Merkmal oder die Kombination selbst nicht explizit in den Patentansprüchen oder Ausführungsbeispielen angegeben ist.

### Bezugszeichenliste

- 10: Substrat
- 20: Halbleiterschichtenfolge
- 30: Konversionsschicht
- 40: Gehäuse
- A: Verfahrensschritt A
- B: Verfahrensschritt B
- C: Verfahrensschritt C
- n: Stoffmenge
- |η*|: absolute Viskosität
- n_{D}²⁰: Brechungsindex
- H: Härte
- M: Masse
- T: Temperatur
- T₉₅: T₉₅-Wert
- t: Zeit
- Aᵣₑₗ: relative Absorption
- E: Energie
- G: Zusammensetzungsprecursor
- CM: Zusammensetzung

## Patentansprüche

1. Zusammensetzungsprecursor aufweisend ein dreidimensionales Netzwerk aus teilweise miteinander vernetzten Monomereinheiten und einem alkoxyterminierten Oligo- oder Polysiloxan, wobei die Monomereinheiten zumindest ein Trialkoxysilan und zumindest ein Dialkoxysilan umfassen.

2. Zusammensetzungsprecursor gemäß Anspruch 1, aufweisend die allgemeine Strukturformel 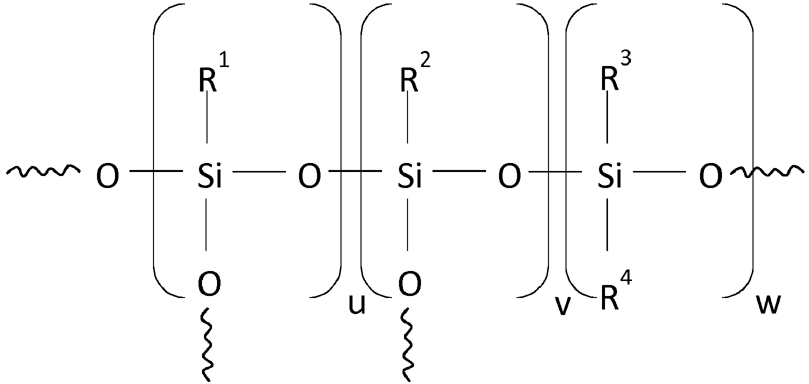 wobei R¹, R², R³ und R⁴ unabhängig voneinander ausgewählt sind aus Aryl, Alkyl, Alkenyl, Allyl, substituiertem Aryl, substituiertem Alkenyl, substituiertem Alkyl und Vinyl, vorzugsweise aus Phenyl und Methyl, wobei u+v+w die Anzahl der eingesetzten Si-Atome ist und u, v und w unabhängig voneinander aus dem Bereich 1 bis 20000 ausgewählt sind.

3. Zusammensetzungsprecursor gemäß einem der vorhergehenden Ansprüche, wobei der Anteil an alkoxyterminiertem Oligo- oder Polysiloxan aus einem Bereich von > 0% bis 10% der Summe der Stoffmengen an Trialkoxysilan und Dialkoxysilan ausgewählt ist.

4. Zusammensetzungsprecursor nach einem der vorhergehenden Ansprüche, der eine Viskosität bei 23°C aufweist, die in einem Bereich von 1000000 mPas bis 100 mPas liegt und/oder eine Viskosität bei 110°C aufweist, die in einem Bereich von 10000 mPas bis 50 mPaS liegt.

5. Zusammensetzungsprecursor gemäß einem der vorhergehenden Ansprüche, der thermisch oder photochemisch aushärtbar ist.

6. Zusammensetzung, die einen thermisch oder photochemisch ausgehärteten Zusammensetzungsprecursor gemäß einem der vorhergehenden Ansprüche umfasst.

7. Zusammensetzung gemäß dem vorhergehenden Anspruch, die eine Shore A Härte von 40 bis <99 aufweist.

8. Zusammensetzung gemäß einem der Ansprüche 6 bis 7, die frei von einem Edelmetallkatalysator ist.

9. Verfahren zur Herstellung eines Zusammensetzungsprecursors mit den Schritten
A) Kondensation von mindestens einem Trialkoxysilan und mindestens einem Dialkoxysilan,
B) Kondensation des Trialkoxysilans und des Dialkoxysilans mit einem alkoxyterminierten Oligo- oder Polysiloxan,
C) Reinigung des kondensierten Trialkoxysilans, Dialkoxysilans und alkoxyterminierten Oligo- oder Polysiloxans, wobei der Verfahrensschritt B) nach dem Verfahrensschritt A) oder gleichzeitig mit dem Verfahrensschritt A) durchgeführt wird.

10. Verfahren gemäß Anspruch 9, wobei die Verfahrensschritte A) und B) bei einer Temperatur durchgeführt werden, die aus dem Bereich 20°C bis 60°C ausgewählt ist, und/oder der Verfahrensschritt C) bei einer Temperatur durchgeführt wird, die aus dem Bereich 70°C bis 150°C ausgewählt ist.

11. Verfahren gemäß einem der Ansprüche 9 bis 10, wobei der Verfahrensschritt A) unter Zugabe einer Säure oder einer Base durchgeführt wird.

12. Verfahren gemäß einem der Ansprüche 9 bis 11, wobei vor dem Verfahrensschritt C) das kondensierte Trialkoxysilan, Dialkoxysilan und alkoxyterminierte Oligo- oder Polysiloxan bei Raumtemperatur gerührt wird.

13. Verfahren zur Herstellung einer Zusammensetzung bei dem ein gemäß einem der Ansprüche 9 bis 12 hergestellter Zusammensetzungsprecursor thermisch oder photochemisch ausgehärtet wird.

14. Verfahren gemäß dem vorhergehenden Anspruch, wobei die thermische Aushärtung bei einer Temperatur aus dem Bereich 150°C bis 250°C und/oder für eine Dauer aus dem Bereich 8h bis 72h durchgeführt wird.

15. Verfahren gemäß einem der Ansprüche 13 oder 14, wobei eine Base oder Säure als Katalysator zu dem Zusammensetzungsprecursor zugegeben wird.

16. Verwendung einer Zusammensetzung gemäß den Ansprüchen 6 bis 8 als Verkapselungsmaterial von optoelektronischen Bauelementen, als Matrixmaterial von Konversionsschichten, als Linsenmaterial, als Korrosionsschutzmaterial, als Komponente in Kompositmaterialien, in Lithographie-Prozessen in der Drucktechnologie.

17. Bauelement aufweisend mindestens ein Bauteil, das eine Zusammensetzung gemäß einem der Ansprüche 6 bis 8 enthält.

18. Bauelement nach dem vorhergehenden Anspruch, das ein optoelektronisches Bauelement ist und eine Verkapselung aufweisend die Zusammensetzung und/oder eine Konversionsionsschicht (20) aufweisend die Zusammensetzung enthält.

19. Bauelement nach dem vorhergehenden Anspruch, wobei die Zusammensetzung in der Konversionsschicht (20) ein Matrixmaterial für einen wellenlängen-konvertierenden Farbstoff ist.
